# EUROPEAN PATENT SPECIFICATION

(11) **EP 4 084 097 B1**
(45) Date of publication and mention of the grant of the patent: **07.10.2026**
(21) Application number: 20906617.4
(22) Date of filing: 28.12.2020
(51) Int. Cl.: H10H 29/80

(54) **LIGHT-EMITTING ELEMENT AND LED DISPLAY DEVICE INCLUDING SAME**
LICHTEMITTIERENDES ELEMENT UND LED-ANZEIGEVORRICHTUNG DAMIT
ÉLÉMENT ÉLECTROLUMINESCENT ET DISPOSITIF D'AFFICHAGE À DEL LE COMPRENANT

(30) Priority: 28.12.2019 US 201962954406 P; 26.03.2020 US 202063000044 P; 23.12.2020 US 202017133623
(43) Date of publication of application: 02.11.2022
(73) Proprietor: Seoul Viosys Co., Ltd, Ansan-si, Gyeonggi-do 15429 (KR)
(72) Inventor: JANG, Jong Min, Ansan-si Gyeonggi-do 15429 (KR); LEE, Sung Hyun, Ansan-si Gyeonggi-do 15429 (KR); KIM, Chang Yeon, Ansan-si Gyeonggi-do 15429 (KR)
(74) Representative: Isarpatent
(86) International application number: PCT/KR2020/019198
(87) International publication number: WO 2021/133140

(56) References cited:
- JP-A- 2011 176 045
- KR-A- 20160 053 138
- KR-B1- 101 958 419
- US-A1- 2014 209 955
- US-A1- 2017 338 390
- US-A1- 2019 103 510
- US-A1- 2019 164 944
- US-A1- 2019 189 596
- US-A1- 2019 189 596

## Description

### [TECHNICAL FIELD]

Exemplary embodiments of the invention relate generally to a light emitting device and an LED display apparatus having the same.

### [RELATED ART]

As an inorganic light source, light emitting diodes have been used in various fields including displays, vehicular lamps, general lighting, and the like. With various advantages of light emitting diodes over conventional light sources, such as longer lifespan, lower power consumption, and rapid response, light emitting diodes have been replacing conventional light sources.

Light emitting diodes have been generally used as backlight light sources in display apparatuses. However, LED displays that directly display images using the light emitting diodes have been recently developed.

In general, a display apparatus realizes various colors through mixture of blue, green, and red light. In order to display various images, the display apparatus include a plurality of pixels each including sub-pixels corresponding to blue, green, and red light, respectively, in which a color of a certain pixel is determined based on the colors of the sub-pixels so that images can be displayed through combination of such pixels.

Since LEDs can emit various colors depending upon materials thereof, it is possible to provide a display apparatus by arranging individual light emitting devices emitting blue, green, and red light on a two-dimensional plane. However, when one light emitting device is arranged in each sub-pixel, the number of light emitting devices may be increased, which may require excessive amount of time for a mounting process during manufacture.

Meanwhile, the light emitting devices have been generally mounted on a circuit board or the like using a surface mounting technology. A surface mounting technology allows light emitting devices to be bonded onto a circuit board using a solder paste. However, when the size of light emitting devices become extremely small, such as in micro LEDs, an interval between bump pads of the LEDs may also become extremely small, thus, mounting light emitting devices on a circuit board or the like using a conventional surface mounting technology may not be feasible, and a new technology suitable for mounting the extremely small light emitting devices is required.

US 2019/164944 A1 provides a light emitting device to increase an area of each subpixel without increasing the pixel area. US 2014/209955 A1 provides a semiconductor light-emitting device that is mounted on a package substrate by using flip-chip technology. US 2017/338390 A1 provides a light emitting device in which a pad electrode of a light emitting diode is bonded to a connection pad on a substrate using solder. US 2019/189596 A1 provides a display device using LEDs generally formed by forming individually-grown red (R), green (G), and blue (B) LED structures on a final substrate.

### [Disclosure]

### [Technical Problem]

Light emitting devices constructed according to exemplary embodiments of the invention are capable of reducing time for a mounting process time and a display apparatus having the same.

Exemplary embodiments also provide a light emitting device suitable for probing for electrical measurement and being mounted and a display apparatus having the same.

### [Technical Solution]

The present invention is set out by the appended claims.

An exemplary embodiment provides a light emitting device as defined in claim 1, in which the light emitting device includes: a first light emitting stack; a second light emitting stack disposed under the first light emitting stack; a third light emitting stack disposed under the second light emitting stack; first, second, third, and fourth connection electrodes disposed over the first light emitting stack, and electrically connected to the first, second, and third light emitting stacks; and bonding metal layers disposed on upper surfaces of the first, second, third, and fourth connection electrodes, in which each of the first, second, third, and fourth connection electrodes includes a groove on an upper surface thereof, and the bonding metal layers cover the grooves of the first, second, third, and fourth connection electrodes, respectively.

An exemplary embodiment provides a display apparatus, in which the display apparatus includes a display substrate having bonding pads, and light emitting devices disposed on the display substrate, each of the light emitting devices, including: a first light emitting stack; a second light emitting stack disposed under the first light emitting stack; a third light emitting stack disposed under the second light emitting stack; first, second, third, and fourth connection electrodes disposed over the first light emitting stack, and electrically connected to the first, second, and third light emitting stacks; and bonding metal layers disposed on upper surfaces of the first, second, third, and fourth connection electrodes, in which each of the first, second, third, and fourth connection electrodes includes a groove on an upper surface thereof, the bonding metal layers cover the grooves of the first, second, third, and fourth connection electrodes, respectively, and the bonding metal layers are eutectic bonded to the bonding pads.

### [Description of Drawings]

FIG. 1A is a schematic plan view of a light emitting device according to an exemplary embodiment.
FIG. 1B and FIG. 1C are schematic cross-sectional views taken along lines A-A' and B-B' of FIG. 1A, respectively.
FIG. 2 is a schematic cross-sectional view of a light emitting stack structure according to an exemplary embodiment.
FIGS. 3A, 4A, 5A, 6A, 7A, 8A, 9A, 10A, 11A, 12A, 13A, and 14A are plan views illustrating a process of manufacturing a light emitting device according to an exemplary embodiment.
FIGS. 3B, 4B, 5B, 6B, 7B, 8B, 9B, 10B, 11B, 12B, 13B, and 14B are schematic cross-sectional views taken along line A-A' of FIGS. 3A, 4A, 5A, 6A, 7A, 8A, 9A, 10A, 11A, 12A, 13A, and 14A, respectively.
FIGS. 3C, 4C, 5C, 6C, 7C, 8C, 9C, 10C, 11C, 12C, 13C, and 14C are schematic cross-sectional views taken along line B-B' of FIGS. 3A, 4A, 5A, 6A, 7A, 8A, 9A, 10A, 11A, 12A, 13A, and 14A, respectively.
FIGS. 15A, 15B, 15C, and 15D are schematic cross-sectional views illustrating a method of forming a bonding metal layer according to an exemplary embodiment.
FIGS. 16A and 16B are cross-sectional views of a bonding metal layer according to exemplary embodiments.
FIG. 17A is a schematic plan view of a display apparatus according to an exemplary embodiment.
FIG. 17B is a schematic cross-sectional view taken along line C-C' of FIG. 17A.

### [BEST MODE]

Hereinafter, embodiments will be described in detail with reference to the accompanying drawings. Accordingly, the present disclosure is not limited to the embodiments disclosed herein and can also be implemented in different forms. In the drawings, widths, lengths, thicknesses, and the like of devices can be exaggerated for clarity and descriptive purposes. When an element or layer is referred to as being "disposed above" or "disposed on" another element or layer, it can be directly "disposed above" or "disposed on" the other element or layer or intervening devices or layers can be present. Throughout the specification, like reference numerals denote like devices having the same or similar functions.

A light emitting device according to an exemplary embodiment includes a first light emitting stack, a second light emitting stack disposed under the first light emitting stack, a third light emitting stack disposed under the second light emitting stack, first, second, third, and fourth connection electrodes disposed over the first light emitting stack, and electrically connected to the first, second, and third light emitting stacks, and bonding metal layers disposed on upper surfaces of the first, second, third, and fourth connection electrodes, in which each of the first, second, third, and fourth connection electrodes includes a groove on an upper surface thereof, and the bonding metal layers cover the grooves of the first, second, third, and fourth connection electrodes, respectively.

Since the light emitting device having a structure in which the first, second, and third light emitting stacks are stacked one above another is provided, a mounting process time may be reduced. Furthermore, since the bonding metal layers and the connection electrodes are included together, the light emitting device suitable for probing for electrical measurement and being mounted may be provided.

The light emitting device may further include a barrier layer disposed between the bonding metal layer and the connection electrode.

The bonding metal layer may cover the groove on the upper surface of the connection electrode, and also at least partially cover the upper surface of the connection electrode around the groove.

The connection electrode may include Cu, and the bonding metal layer may include Au.

The first light emitting stack may be electrically connected to the first connection electrode and the fourth connection electrode, the second light emitting stack may be electrically connected to the second connection electrode and the fourth connection electrode, and the third light emitting stack may be electrically connected to the third connection electrode and the fourth connection electrode.

As such, each of the first, second, and third light emitting stacks may be independently driven.

In an exemplary embodiment, the first, second, and third connection electrodes may be electrically connected to a second conductivity type semiconductor layer of the first, second, and third light emitting stacks, respectively, and the fourth connection electrode may be electrically connected to first conductivity type semiconductor layers of the first, second, and third light emitting stacks.

The first, second, third, and fourth connection electrodes may be disposed in an upper region of the first conductivity type semiconductor layer of the first light emitting stack.

The light emitting device may further include a first pad electrically connecting the first connection electrode to the first light emitting stack, a second pad electrically connecting the second connection electrode to the second light emitting stack, a third pad electrically connecting the third connection electrode to the third light emitting stack, and a fourth pad electrically connecting the fourth connection electrode to the first, second, and third light emitting stacks. Since the first, second, third, and fourth pads are included, electrical connection between the first to third light emitting stacks and the first to fourth connection electrodes may be easily achieved.

The light emitting device may further include a first lower contact electrode contacting the second conductivity type semiconductor layer of the first light emitting stack, a second lower contact electrode contacting the second conductivity type semiconductor layer of the second light emitting stack, and a third lower contact electrode contacting the second conductivity type semiconductor layer of the third light emitting stack, in which the first, second, and third pads are connected to the first, second, and third lower contact electrodes, respectively.

Since the first, second, and third lower contact electrodes are included, current may be evenly spread to the first, second, and third light emitting stacks.

The light emitting device may further include a first upper contact electrode in ohmic contact with the first conductivity type semiconductor layer of the first light emitting stack, in which the first conductivity type semiconductor layer of the first light emitting stack may have a recessed region, and the first upper contact electrode may be disposed in the recessed region.

The fourth pad may be connected to the first upper contact electrode.

A display apparatus according to another exemplary embodiment includes a display substrate including bonding pads, and light emitting devices disposed on the display substrate, each of the light emitting devices including a first light emitting stack, a second light emitting stack disposed under the first light emitting stack, a third light emitting stack disposed under the second light emitting stack, first, second, third, and fourth connection electrodes disposed over the first light emitting stack, and electrically connected to the first, second, and third light emitting stacks, and bonding metal layers disposed on upper surfaces of the first, second, third, and fourth connection electrodes, in which each of the first, second, third, and fourth connection electrodes includes a groove on an upper surface thereof, the bonding metal layers cover the grooves of the first, second, third, and fourth connection electrodes, respectively, and the bonding metal layers are eutectic bonded to the bonding pads.

In an exemplary embodiment, the eutectic bonding may be a eutectic bonding of Au and In or Au and Sn.

The connection electrode may include Cu, and the bonding metal layer may include Au.

The light emitting device may further include a barrier layer disposed between the bonding metal layer and the connection electrode.

The bonding metal layer may cover the groove on the upper surface of the connection electrode, and also at least partially cover the upper surface of the connection electrode around the groove.

The first light emitting stack may be electrically connected to the first connection electrode and the fourth connection electrode, the second light emitting stack may be electrically connected to the second connection electrode and the fourth connection electrode, and the third light emitting stack may be electrically connected to the third connection electrode and the fourth connection electrode.

The first, second, and third connection electrodes may be electrically connected to a second conductivity type semiconductor layer of the first, second, and third light emitting stacks, respectively, and the fourth connection electrode may be electrically connected to first conductivity type semiconductor layers of the first, second, and third light emitting stacks.

The first, second, third, and fourth connection electrodes may be disposed in an upper region of the first conductivity type semiconductor layer of the first light emitting stack.

The display apparatus may further include a first pad electrically connecting the first connection electrode to the first light emitting stack, a second pad electrically connecting the second connection electrode to the second light emitting stack, a third pad electrically connecting the third connection electrode to the third light emitting stack, and a fourth pad electrically connecting the fourth connection electrode to the first, second, and third light emitting stacks.

Hereinafter, exemplary embodiments of the inventive concepts will be described in detail with reference to the accompanying drawings. Hereinafter, the light emitting device may include a micro-LED, which has a light emission area of 10,000 um² or less as known in the art. In other exemplary embodiments, the micro-LED may have a light emitting area of 4,000 um² or less, and further, 2,500 um² or less as also know in the art.

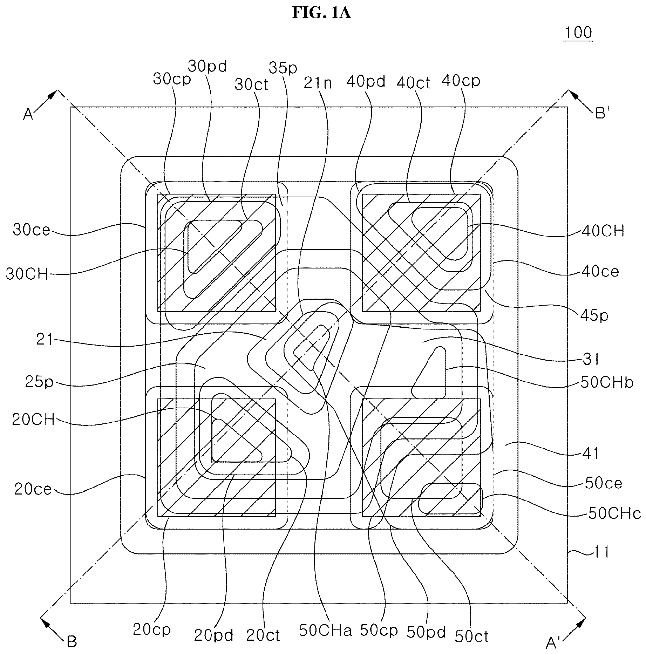

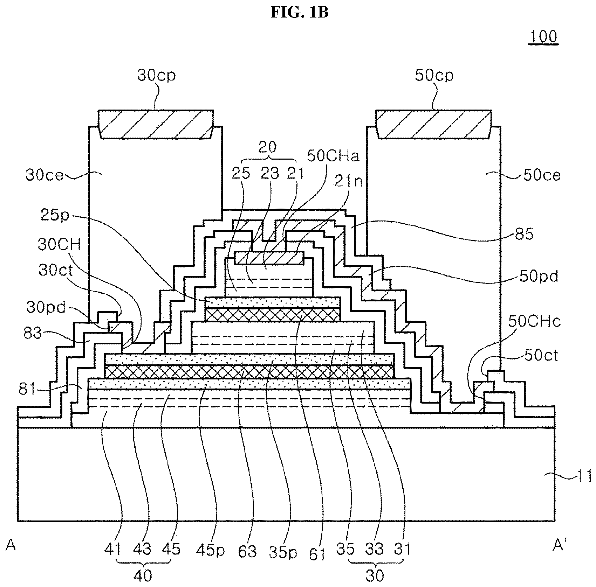

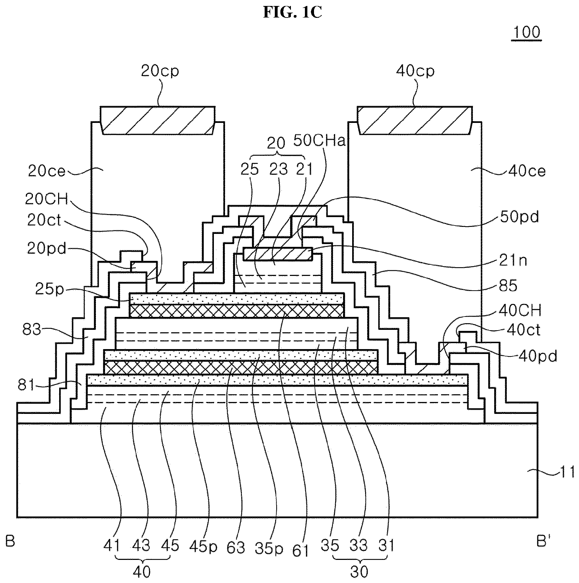

FIG. 1A is a schematic plan view of a light emitting device according to an exemplary embodiment, and FIG. 1B and FIG. 1C are schematic cross-sectional views taken along lines A-A' and B-B' of FIG. 1A, respectively.

Referring to FIGS. 1A, 1B, and 1C, a light emitting device 100 includes a light emitting stack structure, a first connection electrode 20ce, a second connection electrode 30ce, a third connection electrode 40ce, and a fourth connection electrode 50ce formed on the light emitting stack structure, and bonding metal layers 20cp, 30cp, 40cp, and 50cp disposed on the connection electrodes 20ce, 30ce, 40ce, and 50ce, respectively.

The light emitting device 100 includes a first LED sub-unit, a second LED sub-unit, and a third LED sub-unit disposed on a substrate 11. The first LED sub-unit includes a first light emitting stack 20, the second LED sub-unit includes a second light emitting stack 30, and the third LED sub-unit includes a third light emitting stack 40. The light emitting stack structure is exemplarily shown to include three light emitting stacks 20, 30, and 40, but the inventive concepts are not limited to a specific number of light emitting stacks. For example, in some exemplary embodiments which are not part of the invention, the light emitting stack structure may include two or more of light emitting stacks. Hereinafter, the light emitting device 100 will exemplarily be described as including three light emitting stacks 20, 30, and 40 according to an exemplary embodiment.

The substrate 11 may include a light-transmitting insulating material to transmit light. However, in some exemplary embodiments, the substrate 11 may be formed to be translucent or partially transparent so as to transmit only light of a specific wavelength or only a portion of light of a specific wavelength. The substrate 11 may be a growth substrate capable of epitaxially growing the third light emitting stack 40, for example, a sapphire substrate. However, the substrate 11 is not limited to the sapphire substrate, and may include various other transparent insulating materials. For example, the substrate 11 may include glass, quartz, silicon, an organic polymer, or an organic-inorganic composite material, for example, silicon carbide (SiC), gallium nitride (GaN), indium gallium nitride (InGaN), aluminum gallium nitride (AlGaN), aluminum nitride (AlN), gallium oxide (Ga₂O₃), or a silicon substrate. In addition, the substrate 11 may include irregularities on an upper surface thereof, and may be, for example, a patterned sapphire substrate. In this manner, the irregularities formed on the upper surface of the substrate 11 may improve extraction efficiency of light generated from the third light emitting stack 40 contacting the substrate 11. The irregularities of the substrate 11 may be included to selectively increase luminous intensity of the third light emitting stack 40 compared to those of the first light emitting stack 20 and the second light emitting stack 30.

The first, second, and third light emitting stacks 20, 30, and 40 are configured to emit light toward the substrate 11. As such, light emitted from the first light emitting stack 20 may pass through the second and third light emitting stacks 30 and 40. According to an exemplary embodiment, the first, second, and third light emitting stacks 20, 30, and 40 emit light having different peak wavelengths from one another. In an exemplary embodiment, a light emitting stack disposed further away from the substrate 11 emits light having a longer wavelength than that of light emitted from a light emitting stack disposed closer to the substrate 11, and thus, light loss may be reduced. The first light emitting stack 20 emits red light, the second light emitting stack 30 emits green light, and the third light emitting stack 40 emits blue light.

To adjust a color mixing ratio of the first, second, and third light emitting stacks 20, 30, and 40, the second light emitting stack 30 emits light of a shorter wavelength than that of the third light emitting stack 40. Accordingly, luminance intensity of the second light emitting stack 30 may be reduced, and luminance intensity of the third light emitting stack 40 may not be reduced, and thus, luminance intensity ratios of light emitted from the first, second, and third light emitting stacks may be substantially changed. The first light emitting stack 20 is configured to emit red light, the second light emitting stack 30 is configured to emit blue light, and the third light emitting stack 40 is configured to emit green light. As such, luminance intensity of blue light may be relatively reduced, and luminance intensity of green light may be relatively increased, and thus, luminance intensity ratios of red, green, and blue light may be easily adjusted to approach 3: 6: 1. Moreover, light emitting areas of the first, second, and third light emitting stacks 20, 30, and 40 may be about 10,000 µm² or less, and further, 4,000 µm², furthermore, 2,500 µm² or less. In addition, as the light emitting stack is disposed closer to the substrate 11, the emitting area becomes larger, and luminance intensity of green light may be further increased by disposing the third light emitting stack 40 emitting green light closest to the substrate 11.

The first light emitting stack 20 includes a first conductivity type semiconductor layer 21, an active layer 23, and a second conductivity type semiconductor layer 25. According to an exemplary embodiment, the first light emitting stack 20 may include a semiconductor material such as AlGaAs, GaAsP, AlGaInP, and GaP that emits red light, but the inventive concepts are not limited thereto.

A first upper contact electrode 21n may be disposed on the first conductivity type semiconductor layer 21 and may be in ohmic contact with the first conductivity type semiconductor layer 21. A first lower contact electrode 25p may be disposed under the second conductivity type semiconductor layer 25. According to an exemplary embodiment, a portion of the first conductivity type semiconductor layer 21 may be patterned and recessed, and the first upper contact electrode 21n may be disposed in the recessed region of the first conductivity type semiconductor layer 21 to increase an ohmic contact level. The first upper contact electrode 21n may have a single-layer structure or a multiple-layer structure, and may include Al, Ti, Cr, Ni, Au, Ag, Sn, W, Cu, or an alloy thereof, such as Au-Te alloy or Au-Ge alloy, but the inventive concepts are not limited thereto. In an exemplary embodiment, the first upper contact electrode 21n may have a thickness of about 100 nm, and may include metal having high reflectivity to increase light emission efficiency in a downward direction toward the substrate 11.

The second light emitting stack 30 includes a first conductivity type semiconductor layer 31, an active layer 33, and a second conductivity type semiconductor layer 35. According to an exemplary embodiment, the second light emitting stack 30 may include a semiconductor material such as GaN, InGaN, ZnSe that emits blue light, but the inventive concepts are not limited thereto. A second lower contact electrode 35p is disposed under the second conductivity type semiconductor layer 35 of the second light emitting stack 30.

The third light emitting stack 40 includes a first conductivity type semiconductor layer 41, an active layer 43, and a second conductivity type semiconductor layer 45. According to an exemplary embodiment, the third light emitting stack 40 may include a semiconductor material such as GaN, InGaN, GaP, AlGaInP, AlGaP, or the like that emits green light. A third lower contact electrode 45p is disposed on the second conductivity type semiconductor layer 45 of the third light emitting stack 40.

According to an exemplary embodiment, each of the first conductivity type semiconductor layers 21, 31, and 41 and the second conductivity type semiconductor layers 25, 35, and 45 of the first, second, and third light emitting stacks 20, 30, and 40 may have a single-layer structure or a multiple-layer structure, and in some exemplary embodiments, may include a superlattice layer. Moreover, the active layers 23, 33, and 43 of the first, second, and third light emitting stacks 20, 30, and 40 may have a single-quantum well structure or a multiple-quantum well structure.

Each of the first, second, and third lower contact electrodes 25p, 35p, and 45p may include a transparent conductive material that transmits light. For example, the lower contact electrodes 25p, 35p, and 45p may include transparent conductive oxide (TCO) such as SnO, InO₂, ZnO, ITO, ITZO, or the like, without being limited thereto.

A first adhesive layer 61 is disposed between the first light emitting stack 20 and the second light emitting stack 30, and a second adhesive layer 63 is disposed between the second light emitting stack 30 and the third light emitting stack 40. The first and second adhesive layers 61 and 63 may include a non-conductive material that transmits light. For example, the first and second adhesive layers 61 and 63 may include an optically transparent adhesive (OCA), for example, epoxy, polyimide, SU8, spin-on-glass (SOG), or benzocyclobutene (BCB), but the inventive concepts are not limited thereto.

According to the illustrated exemplary embodiment, a first insulation layer 81, a second insulation layer 83, and a third insulation layer 85 are disposed on at least portions of side surfaces of the first, second, and third light emitting stacks 20, 30, and 40. At least one of the first, second, and third insulation layers 81, 83, and 85 may include various organic or inorganic insulating materials, such as polyimide, SiO₂, SiNₓ, Al₂O₃, or the like. For example, at least one of the first, second, and third insulation layers 81, 83, and 85 may include a distributed Bragg reflector (DBR). As another example, at least one of the first, second, and third insulation layers 81, 83, and 85 may include a black organic polymer. In some exemplary embodiments, an electrically floating metal reflection layer is disposed on the first, second, and third insulation layers 81, 83, and 85, and may reflect light emitted from the light emitting stacks 20, 30, and 40 toward the substrate 11. In some exemplary embodiments, at least one of the first, second, and third insulation layers 81, 83, and 85 may have a single-layer structure or a multiple-layer structure formed of two or more insulation layers having different refractive indices.

According to an exemplary embodiment, each of the first, second, and third light emitting stacks 20, 30, and 40 may be driven independently. More specifically, a common voltage may be applied to one of the first and second conductivity type semiconductor layers of each of the light emitting stacks, and an individual emission signal may be applied to the remaining one of the first and second conductivity type semiconductor layers of each of the light emitting stacks. For example, according to an exemplary embodiment, the first conductivity type semiconductor layers 21, 31, and 41 of each of the light emitting stacks 20, 30, and 40 may be n-type, and the second conductivity type semiconductor layers 25, 35, and 45 of each of the light emitting stacks 20, 30, and 40 may be p-type. In this case, the third light emitting stack 40 may have a stacked sequence that is opposite to those of the first light emitting stack 20 and the second light emitting stack 30, and thus, the p-type semiconductor layer 45 may be disposed on the active layer 43 to simplify processes of manufacturing the light emitting device 100. Hereinafter, according to the illustrated exemplary embodiment, the first conductivity type and the second conductivity type semiconductor layers will be described as n-type and p-type, respectively. However, in some exemplary embodiments, n-type and p-type may be reversed.

Each of the first, second, and third lower contact electrodes 25p, 35p, and 45p that are connected to the p-type semiconductor layers 25, 35, and 45 of the light emitting stacks, respectively, may be electrically connected to the first, second, and third connection electrodes 20ce, 30ce, and 40ce to receive corresponding emission signals, respectively. Meanwhile, the n-type semiconductor layers 21, 31, and 41 of the light emitting stacks may be commonly electrically connected to the fourth connection electrode 50ce. As such, the light emitting device 100 may have a common n-type light emitting stack structure in which the n-type semiconductor layers 21, 31, and 41 of the first, second, and third light emitting stacks 20, 30, and 40 are commonly connected, and thus, the first, second, and third light emitting stacks 20, 30, and 40 may be driven independently from one another. Since the light emitting device 100 has the common n-type light emitting structure, sources of voltages applied to the first, second, and third light emitting stacks 20, 30, and 40 may be set to be different from one another.

The light emitting device 100 according to the illustrated exemplary embodiment has the common n-type structure, but the inventive concepts are not limited thereto. For example, in some exemplary embodiments, the first conductivity type semiconductor layers 21, 31, and 41 of each of the light emitting stacks may be p-type, and the second conductivity type semiconductor layer 25, 35, and 45 of each of the light emitting stacks may be n-type, and thus, a common p-type light emitting stack structure may be formed. In addition, in some exemplary embodiments, the stacked sequence of each of the light emitting stacks is not limited to that shown in the drawing, but may be variously modified. Hereinafter, the light emitting device 100 will exemplarily be described as having the common n-type light emitting stack structure.

According to the illustrated exemplary embodiment, the light emitting device 100 includes a first pad 20pd, a second pad 30pd, a third pad 40pd, and a fourth pad 50pd. The first pad 20pd is electrically connected to the first lower contact electrode 25p through a first contact hole 20CH defined through the first and second insulation layers 81 and 83. The first connection electrode 20ce is electrically connected to the first pad 20pd through a first through hole 20ct defined through the third insulation layer 85. The second pad 30pd is electrically connected to the second lower contact electrode 35p through a second contact hole 30CH defined through the first and second insulation layers 81 and 83. The second connection electrode 30ce is electrically connected to the second pad 30pd through a second through hole 30ct defined through the second insulation layer 83.

The third pad 40pd is electrically connected to the third lower contact electrode 45p through the third contact hole 40CH defined through the first and second insulation layers 81 and 83. The third connection electrode 40ce is electrically connected to the third pad 40pd through a third through hole 40ct defined through the second insulation layer 83. The fourth pad 50pd is connected to the first conductivity type semiconductor layers 21, 31, and 41 of the first, second, and third light emitting stacks 20, 30, and 40 through a first sub-contact hole 50CHa, a second sub-contact hole 50CHb, and a third sub-contact hole 50CHc defined on the first conductive type semiconductor layers 21, 31, and 41 of the first, second, and third light emitting stacks 20, 30, and 40. In particular, the first sub-contact hole 50CHa may expose the first upper contact electrode 21n, and the fourth pad 50pd may be connected to the first upper contact electrode 21n through the first sub-contact hole 50CHa. In this manner, the fourth pad 50pd can be electrically connected to the first conductivity type semiconductor layers 21, 31, and 41 through the sub-contact holes 50CHa, 50CHb, and 50CHc, so that a manufacturing process of the light emitting device 100 may be simplified. The fourth connection electrode 50ce is electrically connected to the fourth pad 50pd through a fourth through hole 50ct defined through the second insulation layer 83.

In the illustrated exemplary embodiment, although each of the connection electrodes 20ce, 30ce, 40ce, and 50ce are shown and described as directly contacting the pads 20pd, 30pd, 40pd, and 50pd, in some exemplary embodiments, the connection electrodes 20ce, 30ce, 40ce, and 50ce may not be directly connected to the pads 20pd, 30pd, 40pd, and 50pd, and another connector may be interposed therebetween.

The first, second, third, and fourth pads 20pd, 30pd, 40pd, and 50pd are spaced apart from one another and insulated. According to an exemplary embodiment, each of the first, second, third, and fourth pads 20pd, 30pd, 40pd, and 50pd may cover at least portions of side surfaces of the first, second, and third light emitting stacks 20, 30, and 40. In this manner, heat generated from the first, second, and third light emitting stacks 20, 30, and 40 may be easily dissipated to the outside.

According to the illustrated exemplary embodiment, each of the connection electrodes 20ce, 30ce, 40ce, and 50ce may have a substantially elongated shape that protrudes upward from the substrate 11. The connection electrodes 20ce, 30ce, 40ce, and 50ce may include metal such as Cu, Ni, Ti, Sb, Zn, Mo, Co, Sn, Ag, or an alloy thereof, but the inventive concepts are not limited thereto. For example, each of the connection electrodes 20ce, 30ce, 40ce, and 50ce may include two or more metals or a plurality of different metal layers to reduce stress from the elongated shape of the connection electrodes 20ce, 30ce, 40ce, and 50ce. The connection electrodes 20ce, 30ce, 40ce, and 50ce may be formed of, for example, Cu which facilitate deposition using plating at low cost. Cu forms a natural oxide film, which can be removed by flux in a solder paste in a surface mounting technology using the solder paste. However, in the surface mounting technology using the solder paste, when a distance between the connection electrodes 20ce, 30ce, 40ce, and 50ce is less than about 50 µm, an electrical short may occur between the solder paste. As such, the surface mounting technology may not be feasible for mounting the light emitting device 100.

As a method to bond extremely small light emitting devices such as micro LEDs, eutectic bonding technology may be used. However, the natural oxide film on Cu may prevent the eutectic bonding and cause bonding failure.

As such, according to an exemplary embodiment, the bonding metal layers 20cp, 30cp, 40cp, and 50cp are disposed on the connection electrodes 20ce, 30ce, 40ce, and 50ce, respectively. Each of the connection electrodes 20ce, 30ce, 40ce, and 50ce has a recessed region on an upper surface thereof, and the bonding metal layers 20cp, 30cp, 40cp, and 50cp are disposed in the recessed regions of the connection electrodes 20ce, 30ce, 40ce and 50ce to protrude to the outside, respectively

The bonding metal layers 20cp, 30cp, 40cp, and 50cp may be electrically connected to the connection electrodes 20ce, 30ce, 40ce, and 50ce, respectively. The bonding metal layers 20cp, 30cp, 40cp, and 50cp may be formed of, for example, Au, which can be bonded to a circuit board through eutectic bonding. In this case, a pad disposed on the circuit board may include, for example, In or Sn. The bonding metal layers 20cp, 30cp, 40cp, and 50cp may be formed of In or Sn. However, In is difficult to deposit thick through plating technology, and Sn is difficult to probe to measure electrical characteristics of the light emitting device 100. As such, by forming the bonding metal layers 20cp, 30cp, 40cp, and 50cp with Au, a bonding metal layer having a sufficient thickness may be formed, and further, electrical characteristics of the light emitting device 100 may be easily measured.

In some exemplary embodiments, a barrier layer may be interposed between the connection electrodes 20ce, 30ce, 40ce, and 50ce and the bonding metal layers 20cp, 30cp, 40cp, and 50cp. The barrier layer prevents the bonding metal layers 20cp, 30cp, 40cp, and 50cp from being mixed with the connection electrodes 20ce, 30ce, 40ce, and 50ce. This will be described in more detail again later.

When the light emitting device 100 according to an exemplary embodiment includes a micro LED having a surface area of about 10,000 µm² or less, , or about 4,000 µm² or less, or about 2,500 µm² or less as known in the art, the connection electrodes 20ce, 30ce, 40ce, and 50ce may be overlapped with at least a portion of one of the first, second, and third light emitting stacks 20, 30, and 40 as shown in the drawing. More specifically, the connection electrodes 20ce, 30ce, 40ce, and 50ce may be overlapped with at least one step that is formed on the side surface of the light emitting stack structure. As such, a lower surface of the connection electrode may provide a larger contact area than that of an upper surface thereof, and thus, the connection electrodes 20ce, 30ce, 40ce, and 50ce may be more stably formed on the light emitting stack structure than those of a conventional light emitting device.

In some exemplary embodiments, at least one of the connection electrodes 20ce, 30ce, 40ce, and 50ce may be overlapped with the side surface of each of the light emitting stacks 20, 30, and 40, and thus, the light emitting stacks 20, 30, and 40 may efficiently dissipate heat generated from inside thereof to the outside. Further, when the connection electrodes 20ce, 30ce, 40ce, and 50ce include a reflective material such as metal, the connection electrodes 20ce, 30ce, 40ce, and 50ce may reflect light that is emitted from at least one or more of the light emitting stacks 20, 30, and 40, and thus, luminous efficiency may be improved.

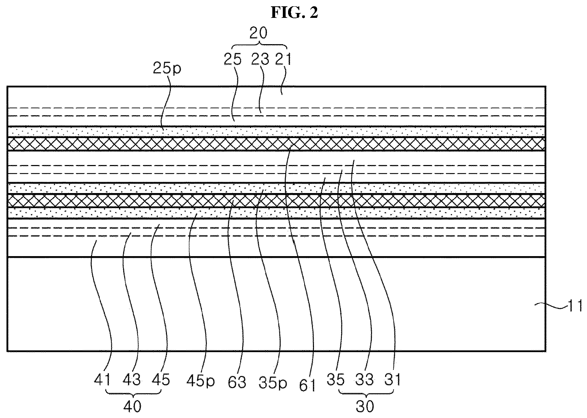

FIG. 2 is a schematic cross-sectional view of a light emitting stack structure according to an exemplary embodiment. The above-described light emitting device 100 is formed by processing the light emitting stack structure.

Referring to FIG. 2, the light emitting stack structure includes a substrate 11, a first light emitting stack 20, a second light emitting stack 30, and a third light emitting stack 40. In addition, lower contact electrodes 25p, 35p, and 45p may be disposed on second conductivity type semiconductor layers 25, 35, and 45 of the light emitting stacks 20, 30, and 40, respectively.

A first conductivity type semiconductor layer 41, a third active layer 43, and a second conductivity type semiconductor layer 45 of the third light emitting stack 40 may be sequentially grown on a substrate 11 by, for example, a metal organic chemical vapor deposition (MOCVD) method or a molecular beam epitaxy (MBE) method. The third lower contact electrode 45p may be formed on the second conductivity type semiconductor layer 45 by, for example, a physical vapor deposition or chemical vapor deposition method, and may include transparent conductive oxide (TCO), such as SnO, InO₂, ZnO, ITO, ITZO, or the like. When the third light emitting stack 40 emits green light according to an exemplary embodiment, the substrate 11 may include Al₂O₃ (for example, a sapphire substrate), and the third lower contact electrode 45p may include transparent conductive oxide (TCO), such as tin oxide. The first and second light emitting stacks 20 and 30 may be similarly formed by sequentially growing a first conductivity type semiconductor layer, an active layer, and a second conductivity type semiconductor layer on a temporary substrate. Lower contact electrodes including transparent conductive oxide (TCO) may be formed by, for example, a physical vapor deposition or a chemical vapor deposition method on the second conductivity type semiconductor layer, respectively.

In an exemplary embodiment, the first light emitting stack 20 may be attached to the second light emitting stack 30 through a first adhesive layer 61, and the second light emitting stack 30 may be attached to the third light emitting stack 40 through a second adhesive layer 63. For example, after the third light emitting stack 40 is grown on the substrate 11, the second light emitting stack 30 grown on the temporary substrate may be attached to the third light emitting stack 40 through the second adhesive layer 63. The temporary substrate on the second light emitting stack 30 may then be removed. Subsequently, the first light emitting stack 20 grown on another temporary substrate may be attached on the second light emitting stack 30 through the first adhesive layer 61. The temporary substrate on the first light emitting stack 20 may be removed from the first light emitting stack 20.

In another exemplary embodiment, the first and second light emitting stacks 20 and 30 may be bonded to each other with the first adhesive layer 61 interposed therebetween, and at least one of the temporary substrates of the first and second light emitting stacks 20 and 30 may be removed by a laser lift-off process, a chemical process, a mechanical process, or the like. Further, the first and second light emitting stacks 20 and 30 may be coupled to the third light emitting stack 40 with the second adhesive layer 63 interposed therebetween, and the remaining temporary substrate of the first and second light emitting stacks 20 and 30 may be removed by the laser lift-off process, the chemical process, the mechanical process, or the like.

Since the first, second, and third light emitting stacks 20, 30, and 40, the first, second, and third lower contact electrodes 25p, 35p, and 45p, and the adhesive layers 61 and 63 are the same as described above, repeated detailed descriptions thereof will be omitted to avoid redundancy.

Hereinafter, a method of manufacturing the light emitting device 100 using the light emitting stack structure of FIG. 2 will be described in more detail.

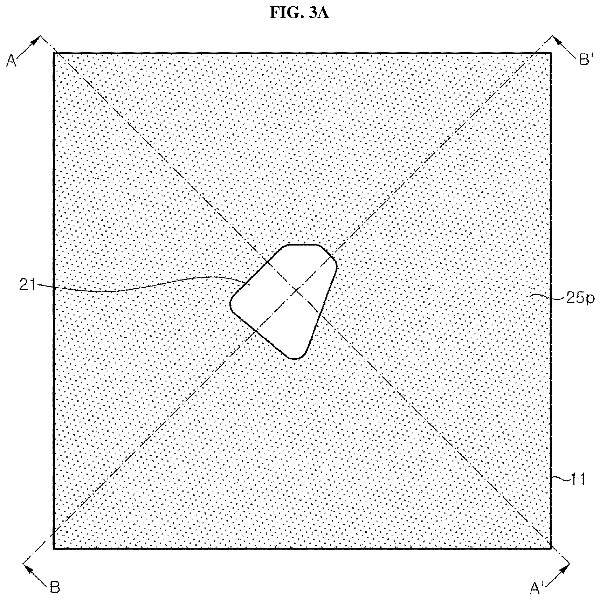

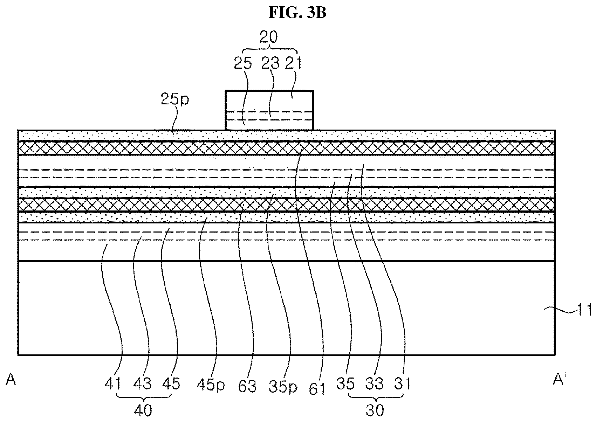

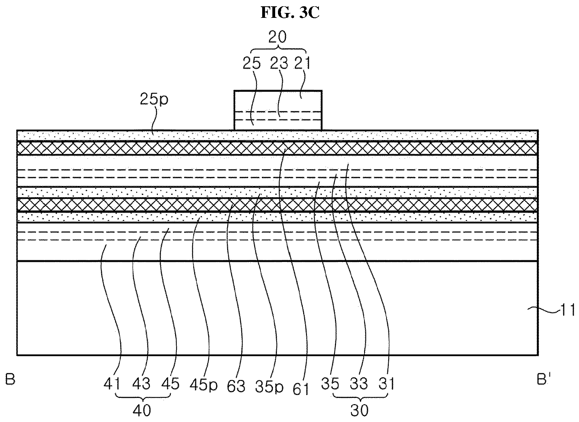

FIGS. 3A, 4A, 5A, 6A, 7A, 8A, 9A, 10A, 11A, 12A, 13A, and 14A are plan views illustrating a process of manufacturing a light emitting device according to an exemplary embodiment. FIGS. 3B, 4B, 5B, 6B, 7B, 8B, 9B, 10B, 11B, 12B, 13B, and 14B are schematic cross-sectional views taken along line A-A' of the corresponding plan views shown in FIGS. 3A, 4A, 5A, 6A, 7A, 8A, 9A, 10A, 11A, 12A, 13A, and 14A, respectively. FIGS. 3C, 4C, 5C, 6C, 7C, 8C, 9C, 10C, 11C, 12C, 13C, and 14C are schematic cross-sectional views taken along line B-B' of the corresponding plan views shown in FIGS. 3A, 4A, 5A, 6A, 7A, 8A, 9A, 10A, 11A, 12A, 13A, and 14A, respectively.

Referring to FIGS. 3A, 3B, and 3C, the first lower contact electrode 25p is exposed by patterning the first conductivity type semiconductor layer 21, the active layer 23, and the second conductivity type semiconductor layer 25. The first conductivity type semiconductor layer 21, the active layer 23, and the second conductivity type semiconductor layer 25 may be patterned using photolithography and etching processes. The photolithography process may be carried out using a first mask, and for example, the first conductivity type semiconductor layer 21, the active layer 23, and the second conductivity type semiconductor layer 25 may be etched using a dry etching technique. After patterning, the first light emitting stack 20 may be surrounded by the exposed lower contact electrode 25p. Although one first light emitting stack 20 is exemplarily shown in the drawings, the first light emitting stack 20 may be patterned in each light emitting device region of the substrate 11.

The first light emitting stack 20 may be disposed in a central portion of the light emitting device region, but the inventive concepts are not limited thereto. A planar shape of the first light emitting stack 20 may have an elongated shape along one diagonal direction, but the inventive concepts are not limited thereto.

The first lower contact electrode 25p may be a transparent electrode, and the second conductivity type semiconductor layer 25 may be a p-type semiconductor layer. The first conductivity type semiconductor layer 21 may be disposed on an upper surface of the first light emitting stack 20, and the first conductivity type semiconductor layer 21 may be an n-type semiconductor layer.

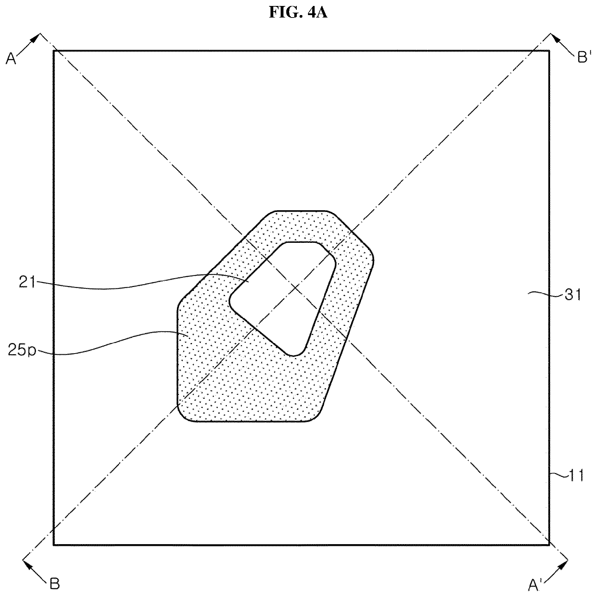

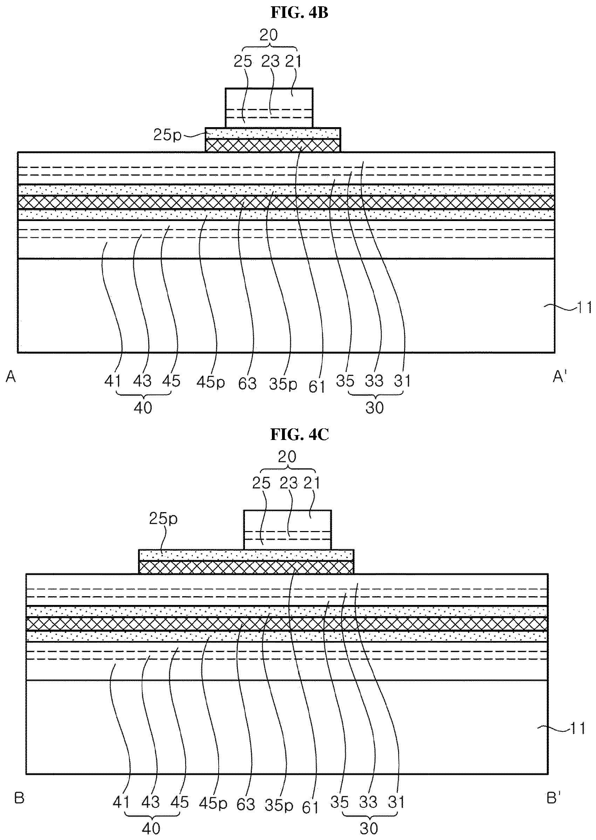

Referring to FIGS. 4A, 4B, and 4C, the first lower contact electrode 25p is patterned so that a portion of the first lower contact electrode 25p surrounds the first light emitting stack 20. The first lower contact electrode 25p may be patterned using a second mask. In this case, the first adhesive layer 61 may also be patterned together. Accordingly, the first conductivity type semiconductor layer 31 may be exposed around the first lower contact electrode 25p.

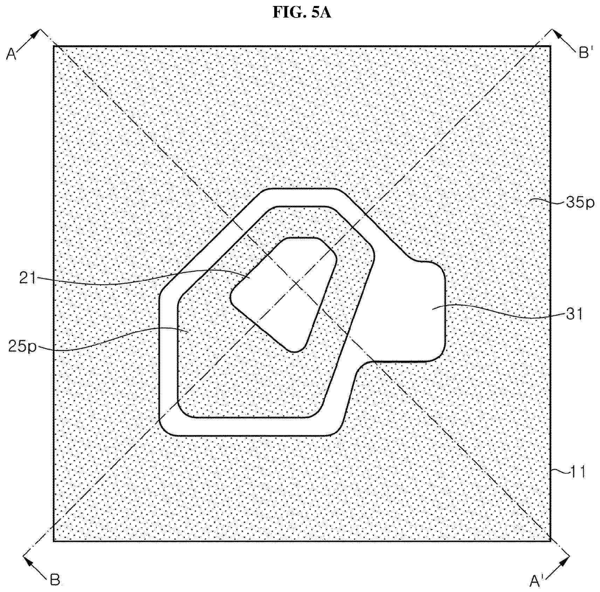

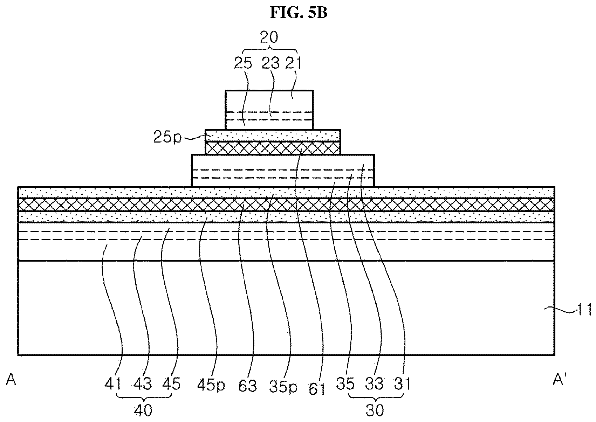

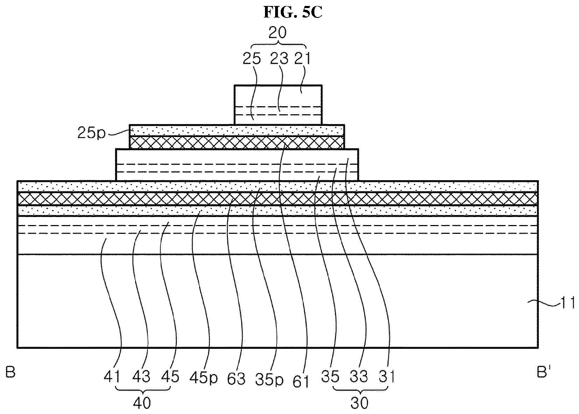

Referring to FIGS. 5A, 5B, and 5C, the second lower contact electrode 35p is exposed by patterning the first conductivity type semiconductor layer 31, the active layer 33, and the second conductivity type semiconductor layer 35. The first conductivity type semiconductor layer 31, the active layer 33, and the second conductivity type semiconductor layer 35 may be patterned using photolithography and etching processes. The photolithography process may be carried out using a third mask, and for example, the first conductivity type semiconductor layer 31, the active layer 33, and the second conductivity type semiconductor layer 35 may be etched using a dry etching technique. After patterning, the second light emitting stack 30 is surrounded by the exposed second lower contact electrode 35p.

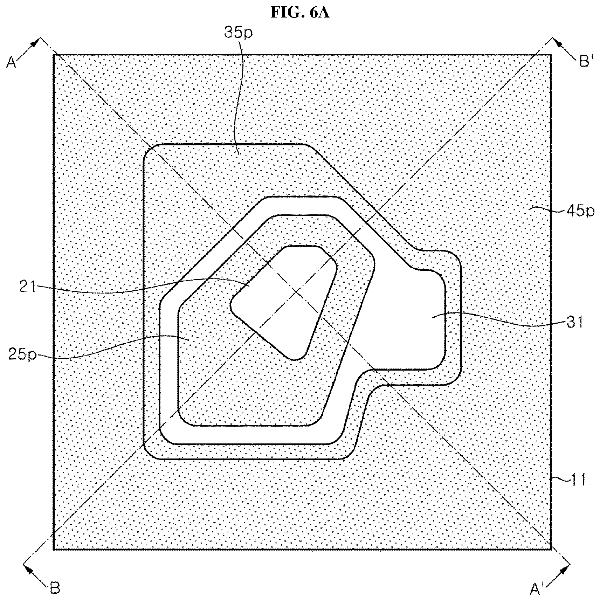

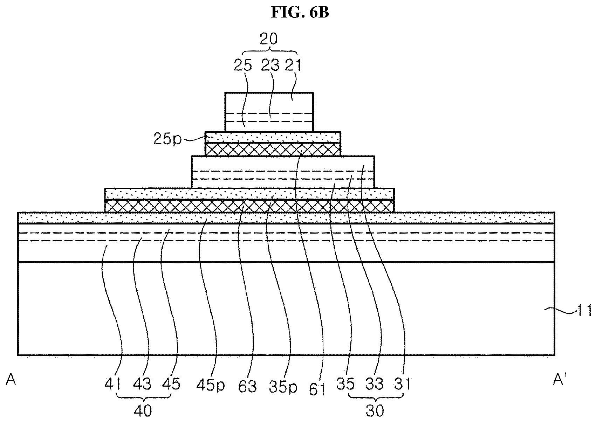

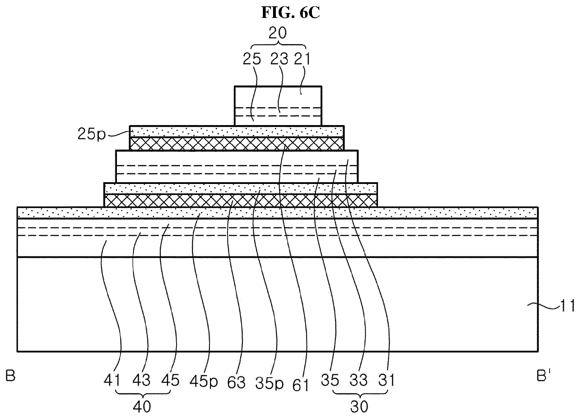

Referring to FIGS. 6A, 6B, and 6C, the second lower contact electrode 35p is patterned so that a portion of the second lower contact electrode 35p surrounds the second light emitting stack 30. The second lower contact electrode 35p may be patterned using a fourth mask. In this case, the second adhesive layer 63 may also be patterned together. Accordingly, the third lower contact electrode 45p may be exposed around the second lower contact electrode 35p.

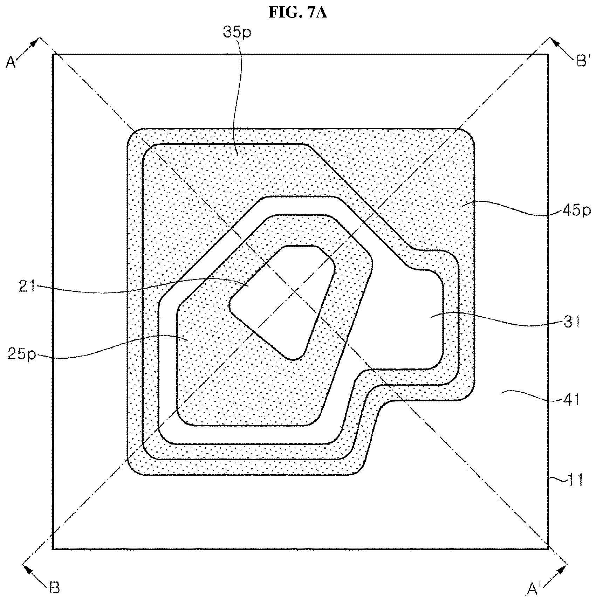

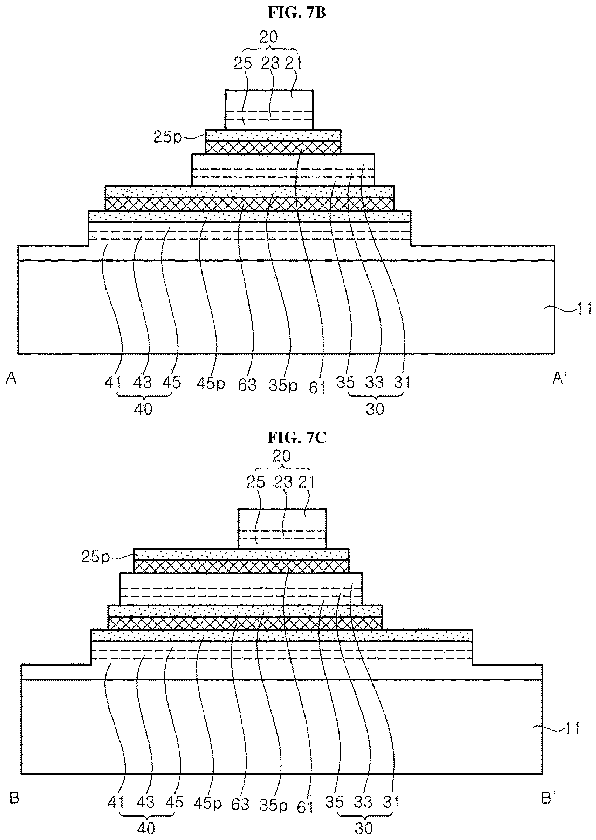

Referring to FIGS. 7A, 7B, and 7C, the third lower contact electrode 45p is patterned so that a portion of the third lower contact electrode 45p surrounds the second lower contact electrode 35p. The third lower contact electrode 45p may be patterned using a fifth mask. Further, the first conductivity type semiconductor layer 41 may be exposed by patterning the second conductivity type semiconductor layer 45 and the active layer 43. For example, the third lower contact electrode 45p may be etched using a wet etching technique, and the second conductivity type semiconductor layer 45 and the active layer 43 may be etched using a dry etching technique. Accordingly, the first conductivity type semiconductor layer 41 is exposed around the third lower contact electrode 45p.

According to the illustrated exemplary embodiment, the first light emitting stack 20 has the smallest area among the light emitting stacks 20, 30, and 40. The third light emitting stack 40 may have the largest area among the light emitting stacks 20, 30, and 40, and thus, luminance intensity of the third light emitting stack 40 may be relatively increased. However, the inventive concepts are not particularly limited to the relative sizes of the light emitting stacks 20, 30, and 40.

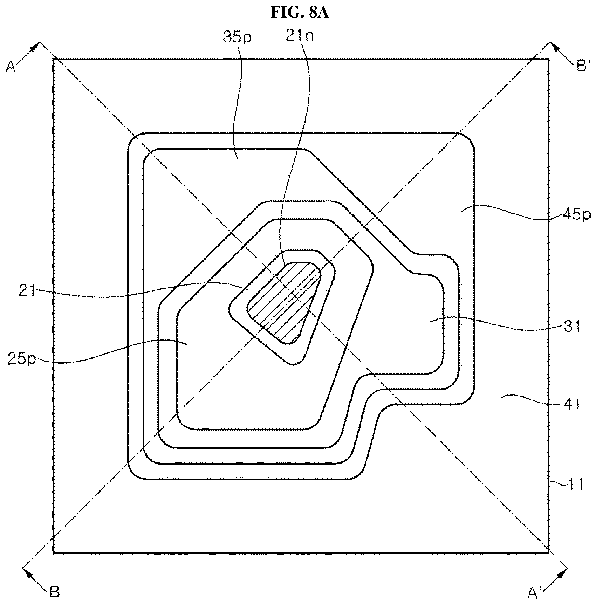

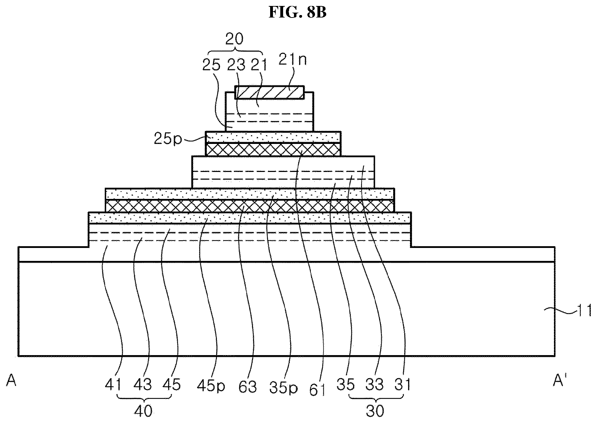

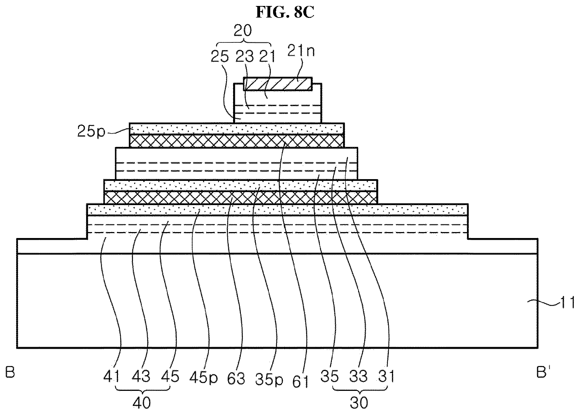

Referring to FIGS. 8A, 8B, and 8C, a portion of an upper surface of the first conductivity type semiconductor layer 21 of the first light emitting stack 20 may be patterned through wet etching to form a first upper contact electrode 21n. The first conductivity type semiconductor layer 21 may be, for example, an n++ GaAs layer, and a portion of an upper surface of the n++ GaAs layer may be recessed through wet etching.

A first upper contact electrode 21n is formed in the recessed region of the first conductivity type semiconductor layer 21. The first upper contact electrode 21n may be formed of, for example, AuGe/Ni/Au/Ti, and may have a thickness of, for example, 100 nm/25 nm/100 nm/10 nm. By partially removing the surface of the n++ GaAs layer, and forming the first upper contact electrode 21n in the recessed region of the first conductivity type semiconductor layer 21, ohmic contact characteristics may be improved.

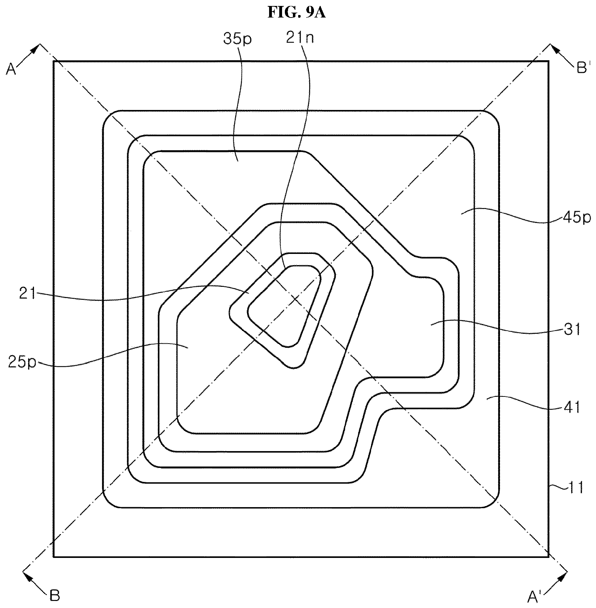

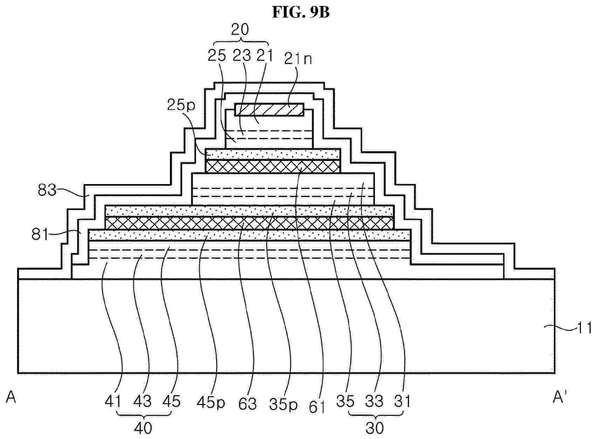

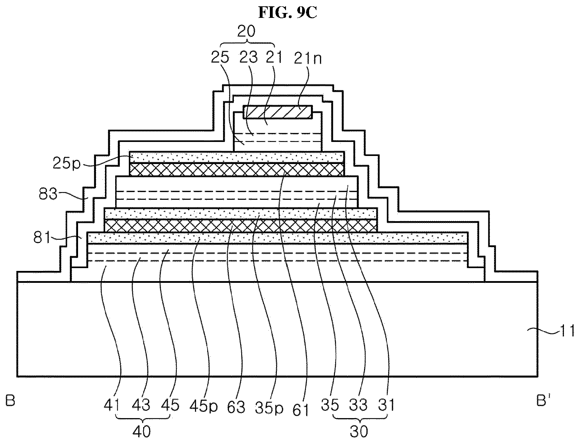

Referring to FIGS. 9A, 9B, and 9C, a first insulation layer 81 covering the light emitting stacks 20, 30, and 40 is formed. The first insulation layer 81 covers the first upper contact electrode 21n. The first insulation layer 81 may be formed of, for example, SiNₓ, SiO₂, Al₂O₃, or the like to have a thickness of about 4000 Å.

Subsequently, the first insulation layer 81 and the first conductivity type semiconductor layer 41 may be patterned to form an isolation region for separating the light emitting device regions. Accordingly, an upper surface of the substrate 11 may be exposed around the first conductivity type semiconductor layer 41.

A second insulation layer 83 may be formed on the first insulation layer 81. The second insulation layer 83 may cover a side surface of the first conductivity type semiconductor layer 41 to protect the first conductivity type semiconductor layer 41. The second insulation layer 83 may be formed of SiNₓ, SiO₂, Al₂O₃, or the like.

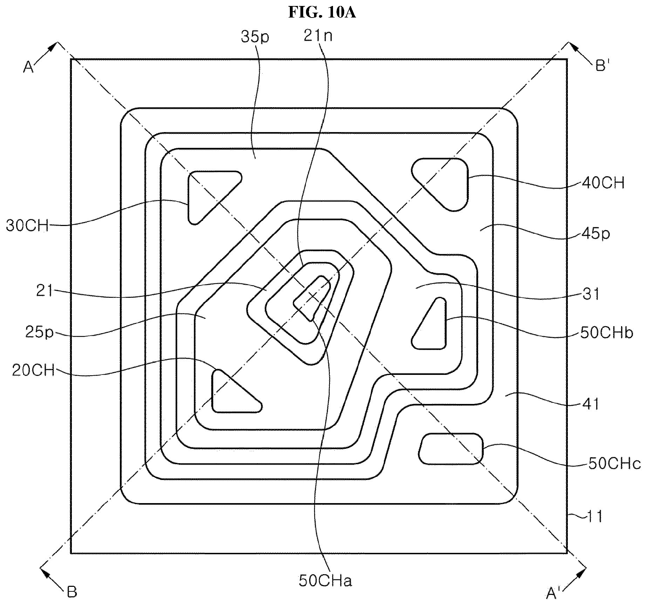

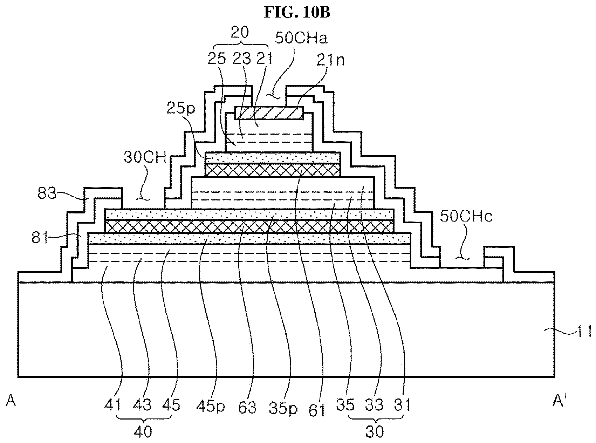

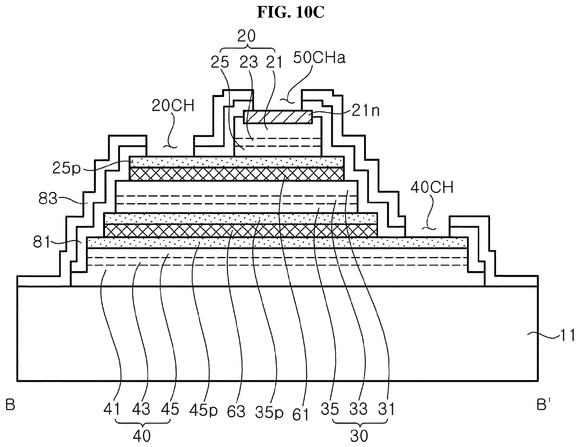

Referring to FIGS. 10A, 10B, and 10C, portions of the first and second insulation layers 81 and 83 may be removed to form first, second, third, and fourth contact holes 20CH, 30CH, 40CH, and 50CH. The first contact hole 20CH is defined on the first lower contact electrode 25p to expose a portion of the first lower contact electrode 25p. The second contact hole 30CH is defined on the second lower contact electrode 35p and may expose the second lower contact electrode 35p. The third contact hole 40CH is defined on the third lower contact electrode 45p and may expose the third lower contact electrode 45p.

The fourth contact hole 50CH provides a path for allowing electrical connection to the first conductive type semiconductor layers 21, 31, and 41 of the first, second, and third light emitting stacks 20, 30, and 40. The fourth contact hole 50CH may include a first sub-contact hole 50CHa, a second sub-contact hole 50CHb, and a third sub-contact hole 50CHc. The first sub-contact hole 50CHa is defined on the first conductivity type semiconductor layer 21 and may expose a portion of the first upper contact electrode 21n, the second sub-contact hole 50CHb is defined on the first conductivity type semiconductor layer 31 and may expose a portion of the first conductivity type semiconductor layer 31, and the third sub-contact hole 50CHc is defined on the first conductivity type semiconductor layer 41 and may expose a portion of the first conductivity type semiconductor layer 41.

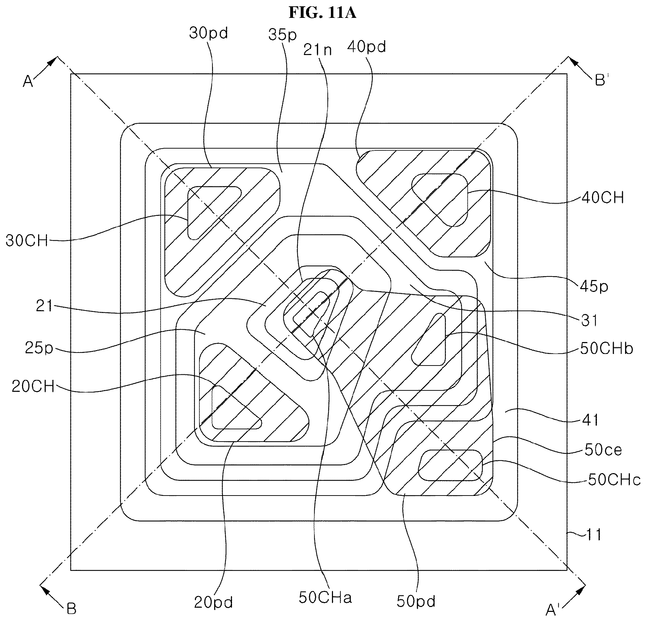

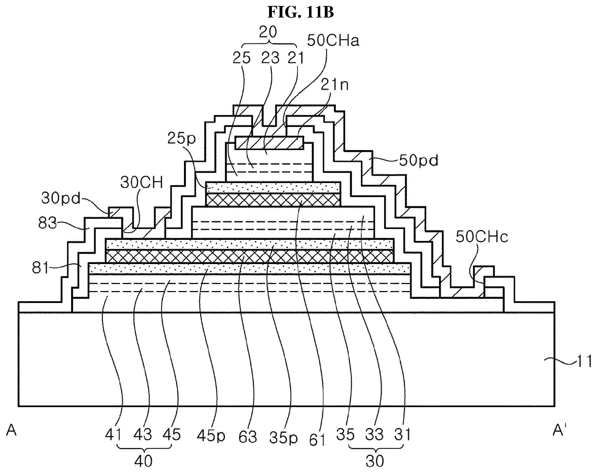

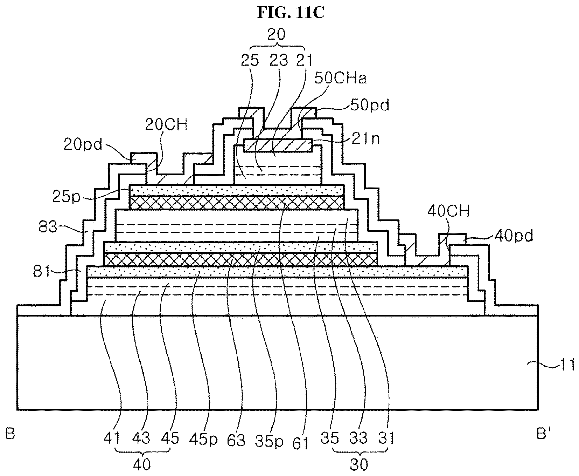

Referring to FIGS. 11A, 11B, and 11C, first, second, third, and fourth pads 20pd, 30pd, 40pd, and 50pd are formed on the first and second insulation layers 81 and 83. The first, second, third, and fourth pads 20pd, 30pd, 40pd, and 50pd may be formed by, for example, forming a conductive layer on a substantially entire surface of the substrate 11, and patterning the conductive layer using photolithography and etching processes.

The first pad 20pd may be formed to overlap with a region where the first contact hole 20CH is formed, and may be connected to the first lower contact electrode 25p through the first contact hole 20CH. The second pad 30pd may be formed to overlap with a region where the second contact hole 30CH is formed, and may be connected to the second lower contact electrode layer 35p through the second contact hole 30CH. The third pad 40pd may be formed to overlap with a region where the third contact hole 40CH is formed, and may be connected to the third lower contact electrode 45p through the third contact hole 40CH. The fourth pad 50pd may be formed to overlap with a region where the fourth contact hole 50CH is formed, particularly regions where the first, second, and third sub-contact holes 50CHa, 50CHb, and 50CHc are formed, and may be electrically connected to the first conductivity type semiconductor layers 21, 31, and 41 of the light emitting stacks 20, 30, and 40.

The first, second, third, and fourth pads 20pd, 30pd, 40pd, and 50pd may include Au, may be formed in a stacked structure of Ti/Ni/Ti/Ni/Ti/Ni/Au/Ti, for example, and thicknesses thereof may be, for example, about 100 nm/50 nm/100 nm/50 nm/100 nm/50 nm/3000 nm/10 nm.

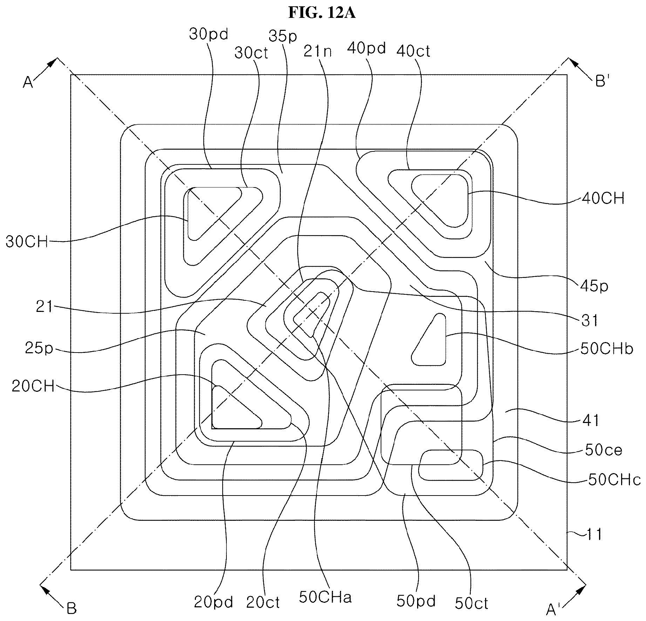

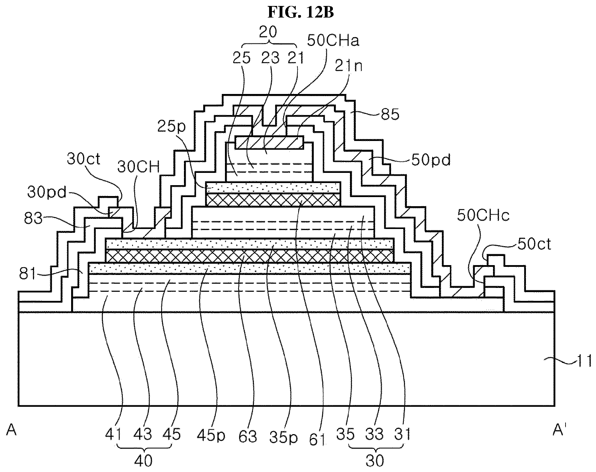

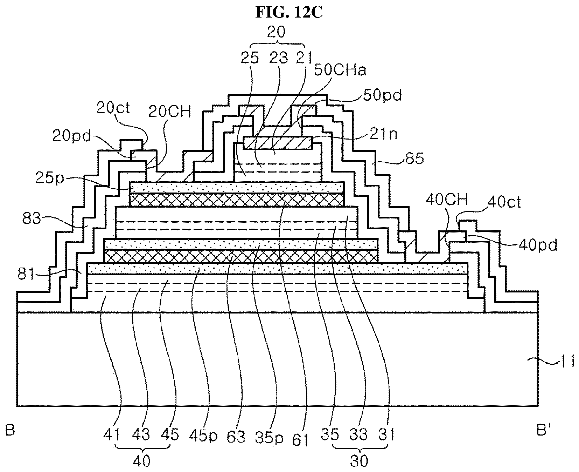

Referring to FIGS. 12A, 12B, and 12C, a third insulation layer 85 may be formed on the second insulation layer 83. The third insulation layer 85 may be formed of SiNₓ, SiO₂, Al₂O₃, or the like.

Subsequently, the third insulation layer 85 may be patterned and first, second, third, and fourth through holes 20ct, 30ct, 40ct, and 50ct exposing the first, second, third, and fourth pads 20pd, 30pd, 40pd, and 50pd may be formed.

The first through hole 20ct formed on the first pad 20pd exposes a portion of the first pad 20pd. The second through hole 30ct formed on the second pad 30pd exposes a portion of the second pad 30pd. The third through hole 40ct formed on the third pad 40pd exposes a portion of the third pad 40pd. The fourth through hole 50ct formed on the fourth pad 50pd exposes a portion of the fourth pad 50pd. In the illustrated exemplary embodiment, the first, second, third, and fourth through holes 20ct, 30ct, 40ct, and 50ct may be defined within regions where the first, second, third, and fourth pads 20pd, 30pd, 40pd, and 50pd are formed, respectively.

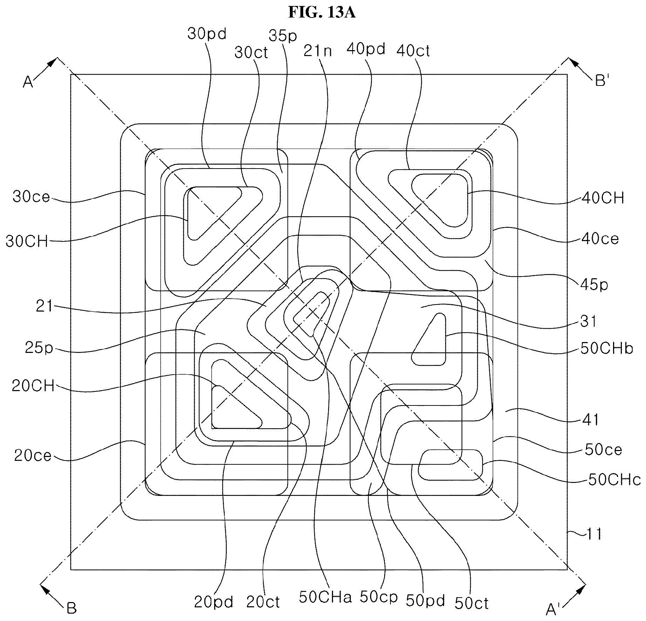

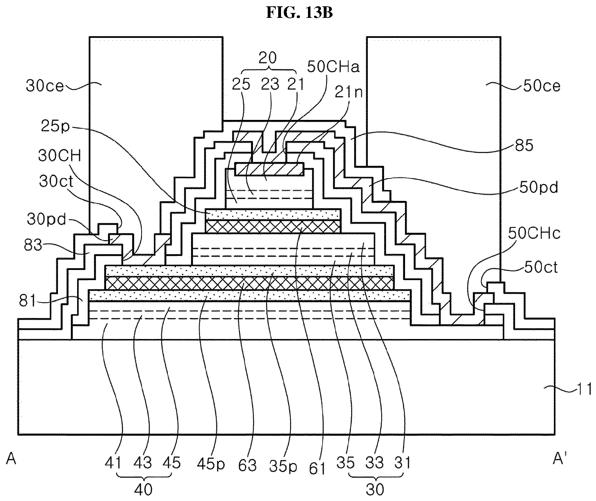

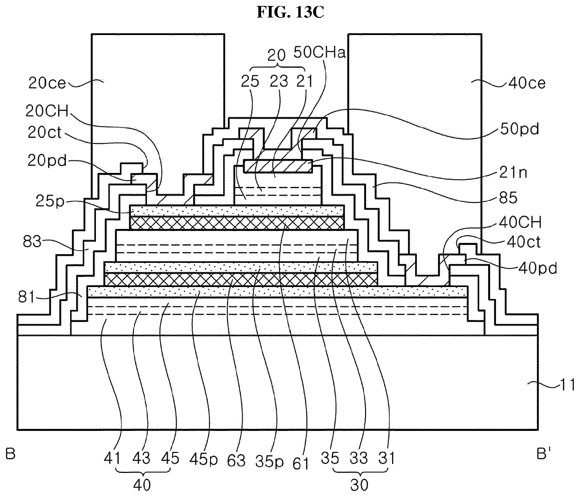

Referring to FIGS.13A, 13B, and13C, first, second, third and fourth connection electrodes 20ce, 30ce, 40ce, and 50ce are formed on the third insulation layer 85 on which the first, second, third and fourth through holes 20ct, 30ct, 40ct, and 50ct are formed. The first connection electrode 20ce may be formed to overlap with a region where the first through hole 20ct is formed, and may be connected to the first pad 20pd through the first through hole 20ct. The second connection electrode 30ce may be formed to overlap with a region where the second through hole 30ct is formed, and may be connected to the second pad 30pd through the second through hole 30ct. The third connection electrode 40ce may be formed to overlap with a region where the third through hole 40ct is formed, and may be connected to the third pad 40pd through the third through hole 40ct. The fourth connection electrode 50ce may be formed to overlap with a region where the fourth through hole 50ct is formed, and may be connected to the fourth pad 50pd through the fourth through hole 50ct.

The first, second, third, and fourth connection electrodes 20ce, 30ce, 40ce, and 50ce a may be spaced apart from one another and formed on the light emitting stack structure. The first, second, third, and fourth connection electrodes 20ce, 30ce, 40ce, and 50ce may be electrically connected to the first, second, third, and fourth pads 20pd, 30pd, 40pd, and 50pd, respectively, and transmit an external signal to each of the light emitting stacks 20, 30, and 40.

A method of forming the first, second, third, and fourth connection electrodes 20ce, 30ce, 40ce, and 50ce is not particularly limited. For example, according to an exemplary embodiment, a seed layer is deposited as a conductive surface on the light emitting stack structure, and a photoresist pattern may be formed so that the seed layer is exposed at a location where connection electrodes will be formed. According to an exemplary embodiment, the seed layer may be deposited to have a thickness of about 1000 Å, but the inventive concepts are not limited thereto. The seed layer may be formed of, for example, Ti/Cu. Subsequently, the seed layer may be plated with metal, such as Cu, Ni, Ti, Sb, Zn, Mo, Co, Sn, Ag or an alloy thereof. In particular, Cu may facilitate plating at low cost.

After plating is completed, a polishing process may be carried out to planarize an upper surface of the connection electrode. The photoresist pattern and the seed layer retained between the connection electrodes may then be removed.

According to the illustrated exemplary embodiment, each of the connection electrodes 20ce, 30ce, 40ce, and 50ce may have a substantially elongated shape to be spaced apart from the substrate 11. In another exemplary embodiment, the connection electrodes 20ce, 30ce, and 40ce may include two or more metals or a plurality of different metal layers to reduce stress from the elongated shape of the connection electrodes 20ce, 30ce, 40ce, and 50ce. However, the inventive concepts are not limited to a specific shape of the connection electrodes 20ce, 30ce, 40ce, and 50ce, and in some exemplary embodiments, the connection electrode may have various shapes.

The connection electrodes 20ce, 30ce, 40ce, and 50ce may be overlapped with at least one step formed on a side surface of the light emitting stack structure. In this manner, a lower surface of the connection electrode may have a larger contact area than the upper surface thereof, and thus, the light emitting device 100 has a more stable structure capable of withstanding subsequent processes.

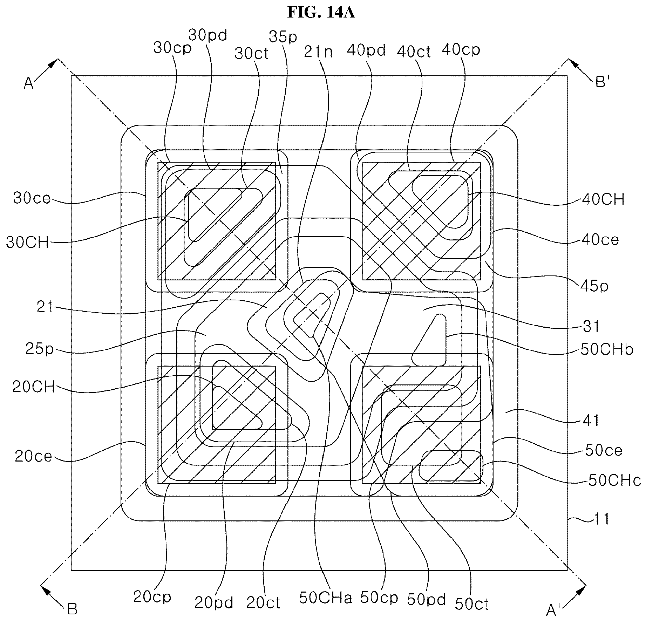

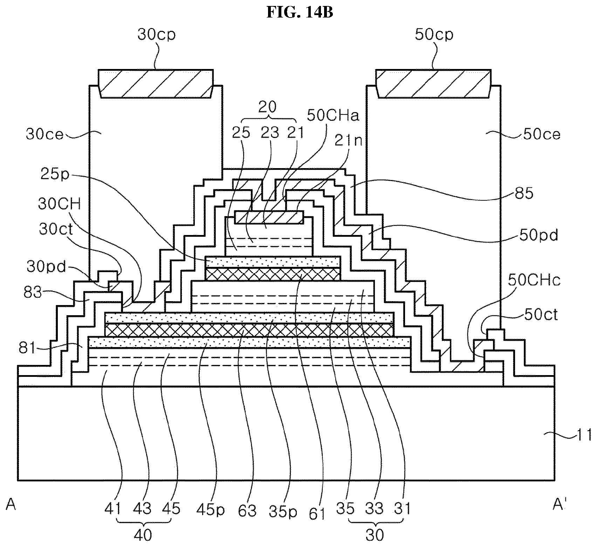

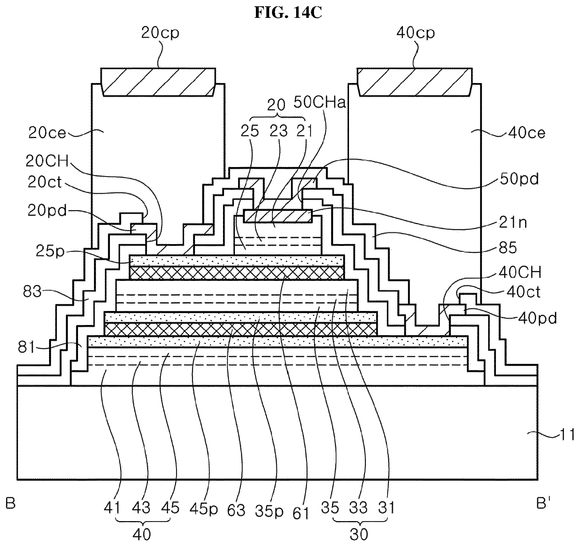

Referring to FIGS. 14A, 14B, and 14C, bonding metal layers 20cp, 30cp, 40cp, and 50cp are formed on the connection electrodes 20ce, 30ce, 40ce, and 50ce. The upper surfaces of the connection electrodes 20ce, 30ce, 40ce, and 50ce may be partially etched to form a recessed region, and the bonding metal layers 20cp, 30cp, 40cp, and 50cp may be formed in the recessed region.

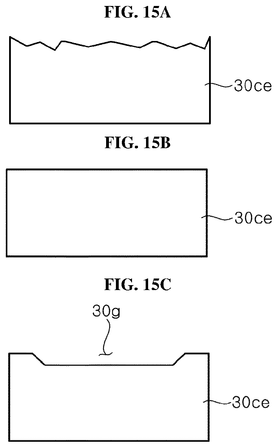

When the connection electrodes 20ce, 30ce, 40ce, and 50ce are formed of metals, while the plating process may be facilitated, however, they may not be suitable for bonding. Further, a natural oxide layer may be formed on the upper surfaces of the connection electrodes 20ce, 30ce, 40ce, and 50ce, which may cause contact failure. As such, by partially removing the upper surfaces of the connection electrodes 20ce, 30ce, 40ce, 50ce and forming the bonding metal layers 20cp, 30cp, 40cp, and 50cp, the natural oxide film may be removed to facilitate the mounting of the light emitting device100 on the circuit board using eutectic bonding technology. A process of forming the bonding metal layers 20cp, 30cp, 40cp, and 50cp will be described in more detail with reference to FIGS. 15A to 15D.

The light emitting device 100 may be provided by separating the substrate 11 for each light emitting device region. The substrate 11 may be separated using a laser scribing technique. In other exemplary embodiments, the substrate 11 may be removed from the third light emitting stack 40.

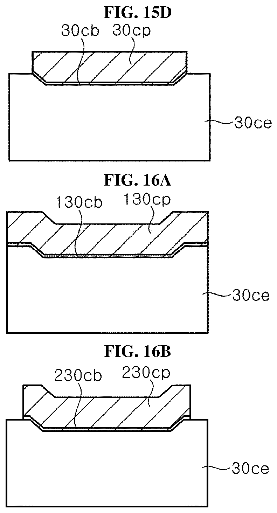

FIGS. 15A, 15B, 15C, and 15D are schematic cross-sectional views illustrating a method of forming a bonding metal layer according to an exemplary embodiment. Hereinafter, a method of forming a bonding metal layer 30cp on a connection electrode 30ce will exemplarily be described.

Referring to FIG. 15A, the connection electrode 30ce is formed through plating using a photoresist pattern. The connection electrode 30ce formed by plating may have a rough surface as illustrated. While the connection electrode 30ce is formed through plating, other connection electrodes 20ce, 40ce, and 50ce may be formed together.

Referring to FIG. 15B, an upper surface of the connection electrode 30ce may be polished to planarize the upper surface thereof. While the surface of the connection electrode 30ce is polished, surfaces of the connection electrodes 20ce, 40ce, and 50ce may also be polished together.

Referring to FIG. 15C, a groove 30g is formed by etching the surface of the connection electrode 30ce. As described above, a natural oxide film and contaminants that may be formed on the surface of the connection electrode 30ce may be removed by an etching process. For example, a photoresist pattern covering an edge of the connection electrode 30ce is formed, and an upper surface of the connection electrode 30ce is etched. When the connection electrode 30ce is formed of Cu, the connection electrode 30ce may be wet etched using a mixed solution of sulfuric acid, phosphoric acid and hydrogen peroxide, a mixed solution of hydrochloric acid, ammonium persulfate, potassium chloride, phosphoric acid, and hydrogen peroxide, or the like. As such, the natural oxide film on the surface of the connection electrode 30ce may be removed, and surface roughness may be improved. The groove 30g may be formed to have a depth of, for example, 100 nm.

Referring to FIG. 15D, a barrier layer 30cb and a bonding metal layer 30cp may be formed using the photoresist pattern, and thereafter, the photoresist pattern may be removed. More particularly, the barrier layer 30cb and the bonding metal layer 30cp may be formed using a lift-off technique.

The barrier layer 30cb may include, for example, a single layer or multiple layers such as Ti, Ni, W, Cr, and Co. For example, the barrier layer 30cb may be formed of Ni, Ti, or Ti/Ni.

The bonding metal layer 30cp may be formed of Au or Au/In. In particular, Au is suitable for probing, as well as for eutectic bonding with In or Sn.

The method of forming the bonding metal layer 30cp on the connection electrode 30ce is exemplarily described above, but the bonding metal layers 20cp, 40cp, 50cp may be formed on the other connection electrodes 20ce, 40ce, and 50ce by the same method, and the bonding metal layers 20cp, 30cp, 40cp, and 50cp may be formed together in the same process.

FIGS. 16A and 16B are cross-sectional views of a bonding metal layer according to exemplary embodiments.

Referring to FIG. 16A, in an exemplary embodiment, a bonding metal layer 130cp may cover an entire upper surface of the connection electrode 30ce. A barrier layer 130cb may cover the entire upper surface of the connection electrode 30ce, and the bonding metal layer 130cp may be disposed on the barrier layer 130cb. More particularly, the barrier layer 130cb may cover the upper surface of the connection electrode 30ce at the outside of a groove 30g as well as the inside of the groove 30g.

For example, after a portion of the upper surface of the connection electrode 30ce is exposed using a first photoresist pattern, the groove 30g is formed using a wet etching technique. Subsequently, the first photoresist pattern is removed, and the entire upper surface of the connection electrode 30ce is exposed using a second photoresist pattern. Thereafter, the barrier layer 130cb and the bonding metal layer 130cp may be formed using the second photoresist pattern.

Referring to FIG. 16B, in an exemplary embodiment, a barrier layer 230cb and a bonding metal layer 230cp may cover the groove 30g of the connection electrode 30ce, and further, may partially cover the upper surface of the connection electrode 30ce around the groove 30g. As such, an edge of the upper surface of the connection electrode 30ce may be exposed to the outside.

For example, after the portion of the upper surface of the connection electrode 30ce is exposed using the first photoresist pattern, the groove 30g is formed using a wet etching technique. Subsequently, the first photoresist pattern is removed, and the portion of upper surface of the connection electrode 30ce including the groove 30g is exposed using the second photoresist pattern. Thereafter, the barrier layer 230cb and the bonding metal layer 230cp may be formed using the second photoresist pattern.

Although the bonding metal layer 30cp have been described according to some exemplary embodiments, the inventive concepts are not limited thereto, and the bonding metal layer 30cp may be formed using various other methods.

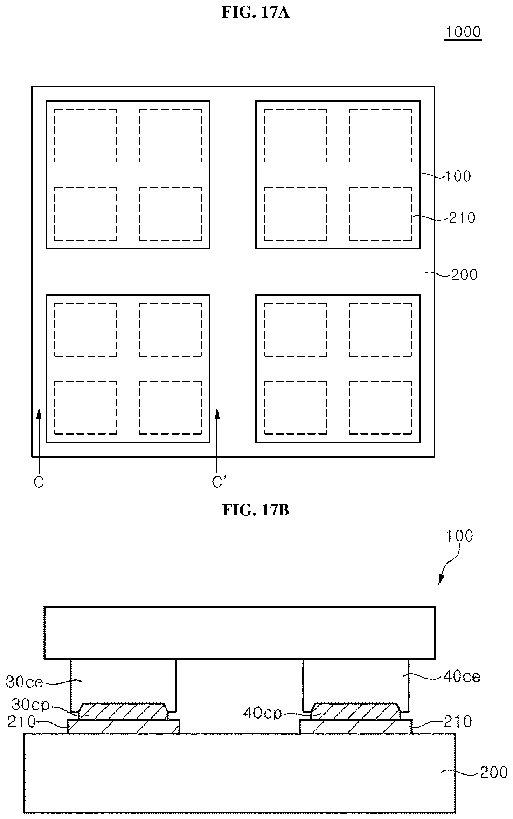

FIG. 17A is a schematic plan view of a display apparatus 1000 according to an exemplary embodiment, and FIG. 17B is a schematic cross-sectional view taken along line C-C' of FIG. 17A.

Referring to FIGS. 17A and 17B, the display apparatus 1000 may include a display substrate 200 and light emitting devices 100. The light emitting devices 100 may be mounted on the display substrate 200 of a final apparatus, such as a display apparatus. The light emitting devices 100 may be individually mounted or mounted in a group on the display substrate 200. Further, the light emitting devices 100 may be packaged as a group so that a plurality of packages may be mounted on the display substrate 200.

The display substrate 200 may include bonding pads 210 for mounting the light emitting devices 100. The bonding pads 210 may be formed of a metal layer including In or Sn, for example.

Bonding metal layers 20cp, 30cp, 40cp, and 50cp are bonded on the bonding pads 210 so that the light emitting device 100 is mounted on the display substrate 200. The bonding pad 210 and the bonding metal layers 20cp, 30cp, 40cp, and 50cp may be attached to one another through eutectic bonding.

Although certain exemplary embodiments and implementations have been described herein, other embodiments and modifications will be apparent from this description. Accordingly, the inventive concepts are not limited to such embodiments, but rather to the broader scope of the appended claims.

## Claims

1. A light emitting device (100), comprising:
a first light emitting stack (20);
a second light emitting stack (30) disposed under the first light emitting stack (20);
a third light emitting stack (40) disposed under the second light emitting stack (30);
first, second, third, and fourth connection electrodes (20ce, 30ce, 40ce, 50ce) disposed over the first light emitting stack (20), and electrically connected to the first, second, and third light emitting stacks (20, 30, 40); and
bonding metal layers (20cp, 30cp, 40cp, 50cp) disposed on upper surfaces of the first, second, third, and fourth connection electrodes (20ce, 30ce, 40ce, 50ce),
wherein:
each of the first, second, third, and fourth connection electrodes (20ce, 30ce, 40ce, 50ce) includes a groove (30g) on an upper surface thereof; and
the bonding metal layers (20cp, 30cp, 40cp, 50cp) cover the grooves of the first, second, third, and fourth connection electrodes (20ce, 30ce, 40ce, 50ce), respectively,
wherein the light emitting device (100) further comprises:
a substrate (11) disposed under the third light emitting stack (40),
wherein the first light emitting stack (20), the second light emitting stack (30), and the third light emitting stack (40) are configured to emit light through the substrate (11),
wherein the third light emitting stack (40) has a light emission area larger than that of the second light emitting stack (30), and the second light emitting stack (30) has a light emission area larger than that of the first light emitting stack (20), and
wherein the first light emitting stack (20) emits red light, the second light emitting stack (30) emits blue light, and the third light emitting stack (40) emits green light.

2. The light emitting device (100) of claim 1, further comprising a barrier layer (30cb) disposed between the bonding metal layer (20cp, 30cp, 40cp, 50cp) and the connection electrode (20ce, 30ce, 40ce, 50ce).

3. The light emitting device (100) of claim 1, wherein the bonding metal layer (20cp, 30cp, 40cp, 50cp) at least partially covers the upper surface of the connection electrode (20ce, 30ce, 40ce, 50ce) around the groove (30g).

4. The light emitting device (100) of claim 1, wherein the connection electrode (20ce, 30ce, 40ce, 50ce) includes Cu, and the bonding metal layer includes Au.

5. The light emitting device (100) of claim 1, wherein:
the first light emitting stack (20) is electrically connected to the first connection electrode (20ce) and the fourth connection electrode (50ce);
the second light emitting stack (30) is electrically connected to the second connection electrode (30ce) and the fourth connection electrode (50ce); and
the third light emitting stack (40) is electrically connected to the third connection electrode and the fourth connection electrode.

6. The light emitting device (100) of claim 5, wherein:
the first, second, and third connection electrodes (20ce, 30ce, 40ce) are electrically connected to a second conductivity type semiconductor layers of the first, second, and third light emitting stacks (20, 30, 40), respectively; and
the fourth connection electrode (50ce) is electrically connected to a first conductivity type semiconductor layers of the first, second, and third light emitting stacks (20, 30, 40).

7. The light emitting device (100) of claim 6, wherein the first, second, third, and fourth connection electrodes (20ce, 30ce, 40ce, 50ce) are disposed in an upper region of the first conductivity type semiconductor layer of the first light emitting stack (20).

8. The light emitting device (100) of claim 6, further comprising:
a first pad (20pd) electrically connecting the first connection electrode (20ce) to the first light emitting stack (20);
a second pad (30pd) electrically connecting the second connection electrode (30ce) to the second light emitting stack (30);
a third pad (40pd) electrically connecting the third connection electrode (40ce) to the third light emitting stack (40); and
a fourth pad (50pd) electrically connecting the fourth connection electrode (50ce) to the first, second, and third light emitting stacks (20, 30, 40).

9. The light emitting device (100) of claim 8, further comprising:
a first lower contact electrode (25p) contacting the second conductivity type semiconductor layer of the first light emitting stack (20);
a second lower contact electrode (35p) contacting the second conductivity type semiconductor layer of the second light emitting stack (30); and
a third lower contact electrode (45p) contacting the second conductivity type semiconductor layer of the third light emitting stack (40),
wherein the first, second, and third pads (20pd, 30pd, 40pd) are connected to the first, second, and third lower contact electrodes (25p, 35p, 45p), respectively.

10. The light emitting device (100) of claim 9, further comprising a first upper contact electrode (21n) in ohmic contact with the first conductivity type semiconductor layer of the first light emitting stack (20),
wherein the first conductivity type semiconductor layer of the first light emitting stack (20) has a recessed region, and the first upper contact electrode (21n) is disposed in the recessed region.

11. The light emitting device (100) of claim 10, wherein the fourth pad (50pd) is connected to the first upper contact electrode (21n).

12. The light emitting device (100) of claim 6, wherein the first conductivity type is an n-type and the second conductivity type is a p-type.

13. The light emitting device (100) of claim 1, wherein the first light emitting stack (20), the second light emitting stack (30), and the third light emitting stack (40) are configured to be independently driven.

## Patentansprüche

1. Lichtemittierende Vorrichtung (100), umfassend:
einen ersten lichtemittierenden Stapel (20);
einen zweiten lichtemittierenden Stapel (30), der unter dem ersten lichtemittierenden Stapel (20) angeordnet ist;
einen dritten lichtemittierenden Stapel (40), der unter dem zweiten lichtemittierenden Stapel (30) angeordnet ist;
eine erste, zweite, dritte und vierte Verbindungselektrode (20ce, 30ce, 40ce, 50ce), die über dem ersten lichtemittierenden Stapel (20) angeordnet sind und elektrisch mit dem ersten, zweiten und dritten lichtemittierenden Stapel (20, 30, 40) verbunden sind; und
Bondmetallschichten (20cp, 30cp, 40cp, 50cp), die auf oberen Flächen der ersten, zweiten, dritten und vierten Verbindungselektrode (20ce, 30ce, 40ce, 50ce) angeordnet sind,
wobei:
die erste, zweite, dritte und vierte Verbindungselektrode (20ce, 30ce, 40ce, 50ce) auf einer oberen Fläche davon jeweils eine Nut (30g) beinhalten; und
die Bondmetallschichten (20cp, 30cp, 40cp, 50cp) die Nuten der ersten, zweiten, dritten und vierten Verbindungselektrode (20ce, 30ce, 40ce, 50ce) jeweils bedecken,
wobei die lichtemittierende Vorrichtung (100) ferner Folgendes umfasst:
ein Substrat (11), das unter dem dritten lichtemittierenden Stapel (40) angeordnet ist,
wobei der erste lichtemittierende Stapel (20), der zweite lichtemittierende Stapel (30) und der dritte lichtemittierende Stapel (40) dazu ausgelegt sind, Licht durch das Substrat (11) zu emittieren,
wobei der dritte lichtemittierende Stapel (40) eine lichtemittierende Fläche aufweist, die größer als die des zweiten lichtemittierenden Stapels (30) ist, und der zweite lichtemittierende Stapel (30) eine lichtemittierende Fläche aufweist, die größer als die des ersten lichtemittierenden Stapels (20) ist, und
wobei der erste lichtemittierende Stapel (20) rotes Licht emittiert, der zweite lichtemittierende Stapel (30) blaues Licht emittiert und der dritte lichtemittierende Stapel (40) grünes Licht emittiert.

2. Lichtemittierende Vorrichtung (100) nach Anspruch 1, ferner umfassend eine Barriereschicht (30cb), die zwischen der Bondmetallschicht (20cp, 30cp, 40cp, 50cp) und der Verbindungselektrode (20ce, 30ce, 40ce, 50ce) angeordnet ist.

3. Lichtemittierende Vorrichtung (100) nach Anspruch 1, wobei die Bondmetallschicht (20cp, 30cp, 40cp, 50cp) die obere Fläche der Verbindungselektrode (20ce, 30ce, 40ce, 50ce) um die Nut (30g) herum zumindest teilweise bedeckt.

4. Lichtemittierende Vorrichtung (100) nach Anspruch 1, wobei die Verbindungselektrode (20ce, 30ce, 40ce, 50ce) Cu beinhaltet und die Bondmetallschicht Au beinhaltet.

5. Lichtemittierende Vorrichtung (100) nach Anspruch 1, wobei:
der erste lichtemittierende Stapel (20) elektrisch mit der ersten Verbindungselektrode (20ce) und der vierten Verbindungselektrode (50ce) verbunden ist;
der zweite lichtemittierende Stapel (30) elektrisch mit der zweiten Verbindungselektrode (30ce) und der vierten Verbindungselektrode (50ce) verbunden ist; und
der dritte lichtemittierende Stapel (40) elektrisch mit der dritten Verbindungselektrode und der vierten Verbindungselektrode verbunden ist.

6. Lichtemittierende Vorrichtung (100) nach Anspruch 5, wobei:
die erste, zweite und dritte Verbindungselektrode (20ce, 30ce, 40ce) jeweils elektrisch mit einer Halbleiterschicht eines zweiten Leitfähigkeitstyps des ersten, zweiten und dritten lichtemittierenden Stapels (20, 30, 40) verbunden sind; und
die vierte Verbindungselektrode (50ce) elektrisch mit Halbleiterschichten eines ersten Leitfähigkeitstyps des ersten, zweiten und dritten lichtemittierenden Stapels (20, 30, 40) verbunden ist.

7. Lichtemittierende Vorrichtung (100) nach Anspruch 6, wobei die erste, zweite, dritte und vierte Verbindungselektrode (20ce, 30ce, 40ce, 50ce) in einem oberen Gebiet der Halbleiterschicht des ersten Leitfähigkeitstyps des ersten lichtemittierenden Stapels (20) angeordnet sind.

8. Lichtemittierende Vorrichtung (100) nach Anspruch 6, ferner umfassend:
ein erstes Pad (20pd), das die erste Verbindungselektrode (20ce) elektrisch mit dem ersten lichtemittierenden Stapel (20) verbindet;
ein zweites Pad (30pd), das die zweite Verbindungselektrode (30ce) elektrisch mit dem zweiten lichtemittierenden Stapel (30) verbindet;
ein drittes Pad (40pd), das die dritte Verbindungselektrode (40ce) elektrisch mit dem dritten lichtemittierenden Stapel (40) verbindet; und
ein viertes Pad (50pd), das die vierte Verbindungselektrode (50ce) elektrisch mit dem ersten, zweiten und dritten lichtemittierenden Stapel (20, 30, 40) verbindet.

9. Lichtemittierende Vorrichtung (100) nach Anspruch 8, ferner umfassend:
eine erste untere Kontaktelektrode (25p), die die Halbleiterschicht des zweiten Leitfähigkeitstyps des ersten lichtemittierenden Stapels (20) kontaktiert;
eine zweite untere Kontaktelektrode (35p), die die Halbleiterschicht des zweiten Leitfähigkeitstyps des zweiten lichtemittierenden Stapels (30) kontaktiert; und
eine dritte untere Kontaktelektrode (45p), die die Halbleiterschicht des zweiten Leitfähigkeitstyps des dritten lichtemittierenden Stapels (40) kontaktiert,
wobei das erste, zweite und dritte Pad (20pd, 30pd, 40pd) mit der ersten, zweiten bzw. dritten unteren Kontaktelektrode (25p, 35p, 45p) verbunden sind.

10. Lichtemittierende Vorrichtung (100) nach Anspruch 9, ferner umfassend eine erste obere Kontaktelektrode (21n), die mit der Halbleiterschicht des ersten Leitfähigkeitstyps des ersten lichtemittierenden Stapels (20) in ohmschem Kontakt steht,
wobei die Halbleiterschicht des ersten Leitfähigkeitstyps des ersten lichtemittierenden Stapels (20) ein vertieftes Gebiet aufweist und die erste obere Kontaktelektrode (21n) in dem vertieften Gebiet angeordnet ist.

11. Lichtemittierende Vorrichtung (100) nach Anspruch 10, wobei das vierte Pad (50pd) mit der ersten oberen Kontaktelektrode (21n) verbunden ist.

12. Lichtemittierende Vorrichtung (100) nach Anspruch 6, wobei der erste Leitfähigkeitstyp ein n-Typ ist und der zweite Leitfähigkeitstyp ein p-Typ ist.

13. Lichtemittierende Vorrichtung (100) nach Anspruch 1, wobei der erste lichtemittierende Stapel (20), der zweite lichtemittierende Stapel (30) und der dritte lichtemittierende Stapel (40) dazu ausgelegt sind, unabhängig angesteuert zu werden.

## Revendications

1. Dispositif électroluminescent (100), comprenant :
un premier empilement électroluminescent (20) ;
un deuxième empilement électroluminescent (30) disposé sous le premier empilement électroluminescent (20) ;
un troisième empilement électroluminescent (40) disposé sous le deuxième empilement électroluminescent (30) ;
des première, deuxième, troisième et quatrième électrodes de connexion (20ce, 30ce, 40ce, 50ce) disposées sur le premier empilement électroluminescent (20), et connectées électriquement aux premier, deuxième et troisième empilements électroluminescents (20, 30, 40) ; et
des couches métalliques de liaison (20cp, 30cp, 40cp, 50cp) disposées sur des surfaces supérieures des première, deuxième, troisième et quatrième électrodes de connexion (20ce, 30ce, 40ce, 50ce),
dans lequel :
chacune parmi les première, deuxième, troisième et quatrième électrodes de connexion (20ce, 30ce, 40ce, 50ce) comprend une rainure (30g) sur une surface supérieure de celle-ci ; et
les couches métalliques de liaison (20cp, 30cp, 40cp, 50cp) recouvrent les rainures des première, deuxième, troisième et quatrième électrodes de connexion (20ce, 30ce, 40ce, 50ce), respectivement,
le dispositif électroluminescent (100) comprenant en outre :
un substrat (11) disposé sous le troisième empilement électroluminescent (40),
le premier empilement électroluminescent (20), le deuxième empilement électroluminescent (30) et le troisième empilement électroluminescent (40) étant configurés pour émettre de la lumière à travers le substrat (11),
le troisième empilement électroluminescent (40) présentant une surface d'émission de lumière supérieure à celle du deuxième empilement électroluminescent (30), et le deuxième empilement électroluminescent (30) présentant une surface d'émission de lumière supérieure à celle du premier empilement électroluminescent (20), et
le premier empilement électroluminescent (20) émettant une lumière rouge, le deuxième empilement électroluminescent (30) émettant une lumière bleue, et le troisième empilement électroluminescent (40) émettant une lumière verte.

2. Dispositif électroluminescent (100) selon la revendication 1, comprenant en outre une couche barrière (30cb) disposée entre la couche métallique de liaison (20cp, 30cp, 40cp, 50cp) et l'électrode de connexion (20ce, 30ce, 40ce, 50ce).

3. Dispositif électroluminescent (100) selon la revendication 1, dans lequel la couche métallique de liaison (20cp, 30cp, 40cp, 50cp) recouvre au moins partiellement la surface supérieure de l'électrode de connexion (20ce, 30ce, 40ce, 50ce) autour de la rainure (30g).

4. Dispositif électroluminescent (100) selon la revendication 1, dans lequel l'électrode de connexion (20ce, 30ce, 40ce, 50ce) comporte du Cu, et la couche métallique de liaison comprend de l'Au.

5. Dispositif électroluminescent (100) selon la revendication 1, dans lequel :
le premier empilement électroluminescent (20) est connecté électriquement à la première électrode de connexion (20ce) et à la quatrième électrode de connexion (50ce) ;
le deuxième empilement électroluminescent (30) est connecté électriquement à la deuxième électrode de connexion (30ce) et à la quatrième électrode de connexion (50ce) ; et
le troisième empilement électroluminescent (40) est connecté électriquement à la troisième électrode de connexion et à la quatrième électrode de connexion.

6. Dispositif électroluminescent (100) selon la revendication 5, dans lequel :
les première, deuxième et troisième électrodes de connexion (20ce, 30ce, 40ce) sont connectées électriquement à des couches semi-conductrices d'un deuxième type de conductivité des premier, deuxième et troisième empilements électroluminescents (20, 30, 40), respectivement ; et
la quatrième électrode de connexion (50ce) est connectée électriquement à des couches semi-conductrices d'un premier type de conductivité des premier, deuxième et troisième empilements électroluminescents (20, 30, 40).

7. Dispositif électroluminescent (100) selon la revendication 6, dans lequel les première, deuxième, troisième et quatrième électrodes de connexion (20ce, 30ce, 40ce, 50ce) sont disposées dans une région supérieure de la couche semi-conductrice du premier type de conductivité du premier empilement électroluminescent (20).

8. Dispositif électroluminescent (100) selon la revendication 6, comprenant en outre :
un premier plot (20pd) reliant électriquement la première électrode de connexion (20ce) au premier empilement électroluminescent (20) ;
un deuxième plot (30pd) connectant électriquement la deuxième électrode de connexion (30ce) au deuxième empilement électroluminescent (30) ;
une troisième plot (40pd) connectant électriquement la troisième électrode de connexion (40ce) au troisième empilement électroluminescent (40) ; et
un quatrième plot (50pd) connectant électriquement la quatrième électrode de connexion (50ce) aux premier, deuxième et troisième empilements électroluminescents (20, 30, 40).

9. Dispositif électroluminescent (100) selon la revendication 8, comprenant en outre :
une première électrode de contact inférieure (25p) en contact avec la couche semi-conductrice du deuxième type de conductivité du premier empilement électroluminescent (20) ;
une deuxième électrode de contact inférieure (35p) en contact avec la couche semi-conductrice du deuxième type de conductivité du deuxième empilement électroluminescent (30) ; et
une troisième électrode de contact inférieure (45p) en contact avec la couche semi-conductrice du deuxième type de conductivité du troisième empilement électroluminescent (40),
les premier, deuxième et troisième plots (20pd, 30pd, 40pd) étant connectés respectivement aux première, deuxième et troisième électrodes de contact inférieures (25p, 35p, 45p).

10. Dispositif électroluminescent (100) selon la revendication 9, comprenant en outre une première électrode de contact supérieure (21n) en contact ohmique avec la couche semi-conductrice du premier type de conductivité du premier empilement électroluminescent (20),
la couche semi-conductrice du premier type de conductivité du premier empilement électroluminescent (20) présentant une région évidée, et la première électrode de contact supérieure (21n) est disposée dans la région évidée.

11. Dispositif électroluminescent (100) selon la revendication 10, dans lequel le quatrième plot (50pd) est connecté à la première électrode de contact supérieure (21n).

12. Dispositif électroluminescent (100) selon la revendication 6, dans lequel le premier type de conductivité est un type n et le deuxième type de conductivité est un type p.

13. Dispositif électroluminescent (100) selon la revendication 1, dans lequel le premier empilement électroluminescent (20), le deuxième empilement électroluminescent (30) et le troisième empilement électroluminescent (40) sont configurés pour être commandés indépendamment.
